(19) Europäisches Patentamt / European Patent Office / Office européen des brevets

(11) **EP 4 206 119 A1**

(12) **EUROPEAN PATENT APPLICATION**
published in accordance with Art. 153(4) EPC

(43) Date of publication:
**05.07.2023  Bulletin 2023/27**

(21) Application number: **21860937.8**

(22) Date of filing: **18.06.2021**

(51) International Patent Classification (IPC):
**B81B 1/00** (2006.01)          **B01J 13/04** (2006.01)
**B01J 19/00** (2006.01)          **B81C 3/00** (2006.01)

(52) Cooperative Patent Classification (CPC):
**B01J 13/04; B01J 19/00; B81B 1/00; B81C 3/00;
G01N 37/00**

(86) International application number:
**PCT/JP2021/023220**

(87) International publication number:
**WO 2022/044506 (03.03.2022 Gazette 2022/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.08.2020  JP 2020141706**

(71) Applicant: **FUJIFILM Corporation
Tokyo 106-8620 (JP)**

(72) Inventor: **MATSUNO, Ryo
ashigara-shi, Kanagawa 250-0193 (JP)**

(74) Representative: **Meissner Bolte Partnerschaft
mbB
Patentanwälte Rechtsanwälte
Postfach 86 06 24
81633 München (DE)**

(54) **MICROCHANNEL DEVICE, DROPLET PRODUCTION METHOD, BUBBLE PRODUCTION METHOD, MICROCAPSULE PRODUCTION METHOD, MULTIPLE EMULSION PRODUCTION METHOD, METHOD FOR PRODUCING DROPLETS INCLUDING BUBBLES, AND MICROCHANNEL DEVICE MANUFACTURING METHOD**

(57)     The present disclosure provides a microchannel device including a first base having a defining surface that defines a flow channel and containing a polymer that contains a fluorine atom and a second base having a defining surface that defines the flow channel together with the defining surface of the first base, having solvent resistance, and coming into contact with the first base, in which an arithmetic average roughness Ra of a surface of the first base, exposed by peeling the second base from the first base, is 1 $\mu$m or more, and provides a use application thereof.

FIG. 1

EP 4 206 119 A1

**Description**

**BACKGROUND OF THE INVENTION**

1. Field of the Invention

The present disclosure relates to a microchannel device, a production method for a liquid droplet, a production method for an air bubble, a production method for a microcapsule, a production method for a multiple emulsion, a production method for a liquid droplet that encompasses an air bubble, and a manufacturing method for a microchannel device.

2. Description of the Related Art

A microchannel device has attracted attention in technical fields such as biological analysis and high-performance materials (for example, JP2009-47438A). The microchannel device is a device including a micro flow channel through which a fluid flows. The fluid is a general term for a liquid and a gas. The flow channel of the microchannel device is utilized, for example, for mixing, separation, analysis, or reaction. The flow channel of the microchannel device is formed by using a nanofabrication technique such as photolithography. For example, the flow channel of the microchannel device is formed through a process of transferring a shape of a mold produced by using a photoresist to silicone rubber. The flow channel of the microchannel device formed by such a method as described above is defined by the surface of the silicone rubber. However, the silicone rubber may swell and deform due to contact with an organic solvent (for example, acetone or methanol). In order to improve the resistance to an organic solvent, a microchannel device manufactured by using a fluorine elastomer is disclosed, for example, in Ikuko MORITA, Yasuhisa ANDO and Yun Jung HEO, "Microsphere formation using SIFEL microfluidic devices with organic-solvent resistance", Journal of Advanced Mechanical Design, Systems, and Manufacturing, Vol. 11, No.2, 2017.

**SUMMARY OF THE INVENTION**

Most microchannel devices are manufactured by bonding two members to each other. However, despite the fact that a polymer that contains a fluorine atom, such as a fluorine elastomer, has high resistance to an organic solvent, it is difficult to bond a member containing a polymer that contains a fluorine atom to another member in the manufacture of the microchannel device. In a microchannel device manufactured by using a member containing a polymer that contains a fluorine atom, it is required to improve the adhesiveness (also referred to as the adhesion) between a member containing a polymer that contains a fluorine atom and another member.

An object of an aspect of the present disclosure is to provide a microchannel device having excellent solvent resistance and bondability.

An object of another aspect of the present disclosure is to provide a production method for a liquid droplet using a microchannel device having excellent solvent resistance and bondability.

An object of another aspect of the present disclosure is to provide a production method for an air bubble using a microchannel device having excellent solvent resistance and bondability.

An object of another aspect of the present disclosure is to provide a production method for a microcapsule using a microchannel device having excellent solvent resistance and bondability.

An object of another aspect of the present disclosure is to provide a production method for a multiple emulsion using a microchannel device having excellent solvent resistance and bondability.

An object of another aspect of the present disclosure is to provide a production method for a liquid droplet that encompasses an air bubble using a microchannel device having excellent solvent resistance and bondability.

An object of another aspect of the present disclosure is to provide a manufacturing method for a microchannel device having excellent solvent resistance and bondability.

The present disclosure includes the following aspects.

<1> A microchannel device comprising a first base having a defining surface that defines a flow channel and containing a polymer that contains a fluorine atom and a second base having a defining surface that defines the flow channel together with the defining surface of the first base, having solvent resistance, and coming into contact with the first base, in which an arithmetic average roughness Ra of a surface of the first base, exposed by peeling the second base from the first base, is 1 $\mu$m or more.

<2> The microchannel device according to <1>, in which the second base contains at least one selected from the group consisting of a polymer that contains a fluorine atom, glass, and stainless steel.

<3> The microchannel device according to <1> or<2>, in which a contact angle of water on the defining surface of the first base is 90° or more, and a contact angle of water on the defining surface of the second base is 90° or more.

<4> The microchannel device according to <1> or <2>, in which the defining surface of the first base includes a region in which a surfactant is adsorbed, and on the defining surface of the first base, a contact angle of water to the region in which the surfactant is adsorbed is 60° or less, and the defining surface of the second base includes a region in which a surfactant is adsorbed, and on the defining surface of the second base, a contact angle of water to the region in which the surfactant is adsorbed is 60° or less.

<5> The microchannel device according to <4>, in which the surfactant is an alkylene oxide polymer.

<6> The microchannel device according to <4>, in which the surfactant is an ethylene oxide-propylene oxide copolymer.

<7> The microchannel device according to any one of <4> to <6>, in which the defining surface of the first base further includes a region in which the surfactant is not adsorbed, and the defining surface of the second base further includes a region in which the surfactant is not adsorbed.

<8> The microchannel device according to any one of <1> to <7>, in which the flow channel includes a first flow channel part, a second flow channel part that joins the first flow channel part, and a third flow channel part that is connected to a junction of the first flow channel part with the second flow channel part.

<9> The microchannel device according to any one of <1> to <7>, in which the flow channel includes a first flow channel part, a second flow channel part that joins the first flow channel part, a third flow channel part that is connected to a junction of the first flow channel part with the second flow channel part, a fourth flow channel part that joins the third flow channel part, and a fifth flow channel part that is connected to a junction of the third flow channel part with the fourth flow channel part.

<10> The microchannel device according to any one of <1> to <9>, in which the microchannel device is used for producing a liquid droplet.

<11> The microchannel device according to any one of <1> to <9>, in which the microchannel device is used for producing an air bubble.

<12> The microchannel device according to any one of <1> to <9>, in which the microchannel device is used for producing a microcapsule.

<13> The microchannel device according to any one of <1> to <9>, in which the microchannel device is used for producing a multiple emulsion.

<14> The microchannel device according to any one of <1> to <9>, in which the microchannel device is used for producing a liquid droplet that encompasses an air bubble.

<15> A production method for a liquid droplet using the microchannel device according to any one of <1> to <9>, the production method for a liquid droplet, comprising: joining a liquid containing oil and a liquid containing water in the flow channel of the microchannel device to obtain a liquid droplet.

<16> A production method for an air bubble using the microchannel device according to any one of <1> to <9>, the production method for an air bubble, comprising joining a liquid and a gas in the flow channel of the microchannel device to obtain an air bubble.

<17> A production method for a microcapsule using the microchannel device according to any one of <1> to <9>, the production method for a microcapsule, comprising joining a liquid containing oil and a liquid containing water in the flow channel of the microchannel device to obtain a microcapsule.

<18> A production method for a multiple emulsion using the microchannel device according to any one of <1> to <9>, the production method for a multiple emulsion, comprising joining at least three liquids in the flow channel of the microchannel device to obtain a multiple emulsion.

<19> A production method for a liquid droplet that encompasses an air bubble using the microchannel device according to any one of <1> to <9>, the production method for a liquid droplet that encompasses an air bubble, comprising joining a gas, a liquid containing oil, and a liquid containing water in the flow channel of the microchannel device to obtain a liquid droplet that encompasses an air bubble.

<20> A manufacturing method for a microchannel device, comprising preparing a first base having a surface that has a groove and containing a polymer that contains a fluorine atom, subjecting the surface of the first base to a plasma treatment in a presence of an ammonia gas, preparing a second base having a surface for coming into contact with the first base and having solvent resistance, subjecting the surface of the second base to a plasma treatment in a presence of an ammonia gas, and bringing the surface of the second base, subjected to the plasma treatment, into contact with the surface of the first base, subjected to the plasma treatment, to form a flow channel defined by the first base and the second base.

According to an aspect of the present disclosure, there is provided a microchannel device having excellent solvent resistance and bondability.

According to another aspect of the present disclosure, there is provided a production method for a liquid droplet using a microchannel device having excellent solvent resistance and bondability.

According to another aspect of the present disclosure, there is provided a production method for an air bubble using a microchannel device having excellent solvent resistance and bondability.

According to another aspect of the present disclosure, there is provided a production method for a microcapsule using a microchannel device having excellent solvent resistance and bondability.

According to another aspect of the present disclosure, there is provided a production method for a multiple emulsion using a microchannel device having excellent solvent resistance and bondability.

According to another aspect of the present disclosure, there is provided a production method for a liquid droplet that encompasses an air bubble using a microchannel device having excellent solvent resistance and bondability.

According to another aspect of the present disclosure, there is provided a manufacturing method for a microchannel device having excellent solvent resistance and bondability.

## BRIEF DESCRIPTION OF THE DRAWINGS

Fig. 1 is a schematic perspective view illustrating a microchannel device according to a certain embodiment of the present disclosure.

Fig. 2 is a schematic cross-sectional view taken along a line II-II illustrated in Fig. 1.

Fig. 3 is a schematic exploded perspective view of the microchannel device illustrated in Fig. 1.

Fig. 4 is a schematic plan view of the microchannel device illustrated in Fig. 1.

Fig. 5 is a schematic plan view illustrating a flow channel of a microchannel device according to a certain embodiment of the present disclosure.

Fig. 6 is a schematic plan view illustrating a flow channel of a microchannel device according to a certain embodiment of the present disclosure.

Fig. 7 is a schematic plan view illustrating a flow aspect of a fluid in a flow channel of a microchannel device according to a certain embodiment of the present disclosure.

## DESCRIPTION OF THE PREFERRED EMBODIMENTS

Hereinafter, embodiments according to the present disclosure will be described in detail. The present disclosure is not limited to the following embodiments. The following embodiments may be appropriately modified within the scope of the object of the present disclosure.

In a case where the embodiments of the present disclosure are described with reference to the drawings, the description of constitutional elements and reference numerals that are overlapped in the drawings may be omitted. The constitutional elements indicated by the same reference numerals in the drawings mean the same constitutional elements. The dimensional ratio in the drawings does not necessarily indicate the actual dimensional ratio.

The numerical range indicated by using "to" in the present disclosure indicates a range including numerical values described before and after "to" as a lower limit value and an upper limit value, respectively. Regarding numerical ranges that are described stepwise in the present disclosure, an upper limit value or a lower limit value described in a numerical value may be replaced with an upper limit value or a lower limit value of another stepwise numerical range. In addition, regarding a numerical range described in the present disclosure, an upper limit value or a lower limit value described in a numerical value may be replaced with a value described in Examples.

In the present disclosure, the amount of each component in a composition means, in a case where the composition contains a plurality of substances corresponding to such a component, the total amount of the plurality of substances in the composition unless otherwise specified.

In the present disclosure, the ordinal numbers (for example, "first" and "second") are terms that are used to distinguish a present of constitutional elements, and thus they do not limit the number of constitutional elements and the superiority or inferiority of the constitutional elements.

In the present disclosure, the term "step" includes not only an independent step but also a step that cannot be clearly distinguished from other steps, as long as the intended purpose of the step is achieved.

In the present disclosure, "% by mass" and "% by weight" are synonymous, and "parts by mass" and "parts by weight" are synonymous.

In the present disclosure, a combination of two or more preferred aspects is a more preferred aspect.

<Microchannel device>

A microchannel device according to one embodiment of the present disclosure includes a first base having a defining surface that defines a flow channel and containing a polymer that contains a fluorine atom, and a second base having a defining surface that defines the flow channel together with the defining surface of the first base, having solvent resistance, and coming into contact with the first base. In the above-described embodiment, an arithmetic average roughness Ra of a surface of the first base, exposed by peeling the second base from the first base, is 1 μm or more. According to the above-described embodiment, there is provided a microchannel device having excellent solvent resistance and bondability. In the present disclosure, the "bondability" refers to the adhesiveness (also referred to as the adhesion) between the first base and the second base. In the present disclosure, "solvent resistance" means resistance to an organic solvent.

A presumable reason why the microchannel device exhibiting the above-described effect is provided in one embodiment of the present disclosure will be described below. The microchannel device according to one embodiment of the present disclosure includes a first base containing a polymer that contains a fluorine atom and a second base having solvent resistance. Such a first base and such a second base as described above improve the solvent resistance of the microchannel device. Furthermore, in the microchannel device according to one embodiment of the present disclosure, an arithmetic average roughness Ra of a surface (hereinafter, may be referred to as an "exposed surface") of the first base, exposed by peeling the second base from the first base, is 1 μm or more. The arithmetic average roughness Ra of the exposed surface indicates a fracture aspect caused by peeling. For example, in a case where the adhesiveness between the first base and the second base is lower than the cohesive force that acts in the inside of the first base or the second base, the peeling occurs mainly at the interface between the first base and the second base in the process of peeling the second base from the first base. In a case where the peeling occurs at the interface between the first base and the second base, the arithmetic average roughness Ra of the exposed surface is decreased. On the other hand, in a case where the adhesiveness between the first base and the second base is higher than the cohesive force that acts inside the first base or the second base, the fracture occurs mainly in the inside of the first base or the second base in the process of peeling the second base from the first base. In a case where the fracture occurs mainly in the inside of the first base or the second base, the arithmetic average roughness Ra of the exposed surface is increased. That is, the characteristic that "the arithmetic average roughness Ra of the exposed surface is 1 μm or more" indicates that the fracture that occurs in the inside of the first base or the second base predominates in the process of peeling the second base from the first base, in other words, it indicates that the adhesiveness between the first base and the second base is high. Accordingly, according to one embodiment of the present disclosure, there is provided a microchannel device having excellent solvent resistance and bondability. Hereinafter, the microchannel device will be specifically described.

«Arithmetic average roughness Ra of exposed surface»

In the microchannel device according to one embodiment of the present disclosure, the arithmetic average roughness Ra of the surface (that is, the exposed surface) of the first base, exposed by peeling the second base from the first base, is 1 μm or more. From the viewpoint of improving the bondability, the arithmetic average roughness Ra of the exposed surface is preferably 2 μm or more, more preferably 3 μm or more, and particularly preferably 5 μm or more. From the viewpoint of the bondability, the upper limit of the arithmetic average roughness Ra of the exposed surface is not limited. The upper limit of the arithmetic average roughness Ra of the exposed surface may be, for example, 300 μm, 500 μm, or 1,000 μm. The arithmetic average roughness Ra of the exposed surface is preferably 1 μm to 1,000 μm, more preferably 2 μm to 500 μm, and particularly preferably 3 μm to 300 μm.

In the present disclosure, the arithmetic average roughness Ra of the exposed surface is measured according to the following method. First, the second base is peeled from the first base of the microchannel device. The peeling angle is 90°. In other words, the second base is peeled from the first base of the microchannel device at an angle of 90°. By peeling the second base from the first base of the microchannel device, the microchannel device is divided into two test pieces. The two test pieces include a test piece separated on a first base side and a test piece separated on a second base side. The test piece separated on the first base side (hereinafter, referred to as the "first test piece") may include a part of the second base. The arithmetic average roughness Ra of the surface of the first test piece, where the surface has been exposed by the peeling (however, the region in which the flow channel of the microchannel device is defined is excluded) is measured by using a laser optical microscope (for example, VK8550, KEYENCE CORPORATION).

<<First base>>

The microchannel device according to one embodiment of the present disclosure includes a first base having a defining surface that defines a flow channel and containing a polymer that contains a fluorine atom. The first base containing a polymer that contains a fluorine atom improves the solvent resistance of the microchannel device. Hereinafter, the first base will be specifically described.

The kind of the polymer that contains a fluorine atom is not limited. The polymer that contains a fluorine atom in the present disclosure includes a known polymer containing a fluorine atom. Examples of the polymer that contains a fluorine atom include a fluoropolyether, a polytetrafluoroethylene, and a perfluoroalkoxyethylene. From the viewpoint of solvent resistance and transparency, the polymer that contains a fluorine atom is preferably a fluoropolyether. The fluoropolyether is a polymer that contains a fluoroalkyleneoxy group. The fluoropolyether may contain two or more kinds of fluoroalkyleneoxy groups. The fluoroalkyleneoxy group may be, for example, a linear fluoroalkyleneoxy group or a branched fluoroalkyleneoxy group. The fluoroalkyleneoxy group is preferably a perfluoroalkyleneoxy group. The fluoroalkyleneoxy group is preferably a fluoroalkyleneoxy group having 2 to 6 carbon atoms and more preferably a fluoroalkyleneoxy group having 2 to 4 carbon atoms. The polymer that contains a fluorine atom may contain, for example, an atom other than the fluorine atom and the carbon atom. The polymer that contains a fluorine atom preferably contains a silicon atom. Examples of the commercially available product of the polymer that contains a fluorine atom include X-71C-8115A/B, X-71C-8015A/B, X-71-358-4, and X-71-359 (all of which are a fluorine elastomer, Shin-Etsu Chemical Co., Ltd.). The first base may include two or more kinds of polymers that contain a fluorine atom.

The content of the polymer that contains a fluorine atom in the first base is not limited. From the viewpoint of improving solvent resistance, the content of the polymer that contains a fluorine atom in the first base is preferably 70% by mass to 100% by mass, preferably 80% by mass to 100% by mass, and particularly preferably 90% by mass to 100% by mass, with respect to the total mass of the first base. The content of the polymer that contains a fluorine atom in the first base may be less than 100% by mass with respect to the total mass of the first base.

The defining surface of the first base defines the flow channel of the microchannel device. That is, the defining surface of the first base is the surface of the base that faces the flow channel. The number of defining surfaces of the first base is not limited. The first base may have two or more defining surfaces. The shape of the defining surface of the first base is not limited. The defining surface of the first base may be, for example, a flat surface or a curved surface.

In a certain embodiment, the contact angle of water on the defining surface of the first base (hereinafter, simply referred to as the "contact angle" in this paragraph) is preferably 90° or more, more preferably 95° or more, and particularly preferably 100° or more. In a case where the contact angle is 90° or more, the affinity of the liquid containing water with respect to the defining surface of the first base is decreased. The decrease in the affinity of the liquid containing water with respect to the defining surface of the first base promotes, for example, the formation of water droplets. The upper limit of the contact angle is not limited. The upper limit of the contact angle may be, for example, 140°, 130°, or 120°. The contact angle is preferably 90° to 140°, more preferably 95° to 130°, and particularly preferably 100° to 120°.

In the present disclosure, the contact angle of water is measured according to the following method. At room temperature of 25°C, 2 $\mu$L of pure water is added dropwise onto a target surface that has been made to be horizontal. The contact angle of the liquid droplet one second after the contact of the pure water with the target surface is measured using a contact angle meter (for example, DMs-401, Kyowa Interface Science Co., Ltd.). The obtained value is adopted as the contact angle of water.

The polymer that contains a fluorine atom generally tends to exhibit hydrophobicity. In a microchannel device formed of a hydrophobic material, the hydrophobic solid surface (for example, the defining surface of the first base) that defines a flow channel may adsorb a sample (for example, an enzyme and a protein) that flows through the flow channel. For example, in an analysis using a microchannel device, the adsorption of the sample to the solid surface that defines a flow channel may result in a decrease in the analytical performance and reproducibility of the analysis. In addition, for example, in a production method for an oil droplet using a microchannel device, it is preferable that the solid surface that defines the flow channel has a high affinity with respect to a liquid containing water that is used as a solvent. From the viewpoint of suitability for some use applications as described above, it is preferable to improve the hydrophilicity of at least a part of a solid surface (for example, the defining surface of the first base) that defines a flow channel of a microchannel device according to a certain embodiment.

In a certain embodiment, the defining surface of the first base preferably includes a region in which a surfactant is adsorbed. That is, it is preferable that the surfactant is adsorbed to at least a part of the defining surface of the first base. The region in which the surfactant is adsorbed improves the hydrophilicity of the solid surface that defines the flow channel. The improvement of the hydrophilicity of the solid surface that defines the flow channel promotes, for example, the formation of oil droplets. On the defining surface of the first base, the position of the region in which the surfactant is adsorbed is not limited. The region on which the surfactant is adsorbed may be disposed on an entirety or a part of the defining surface of the first base. The aspect of adsorption is not limited. The adsorption may be, for example, physical adsorption or chemical adsorption. The surfactant adsorbed on the defining surface of the first base is detected, for example, by the time of flight secondary ion mass spectrometry described later. The kind of the surfactant adsorbed on the defining surface of the first base may be one kind or two or more kinds.

The kind of surfactant is not limited. The surfactant in the present disclosure includes known surfactants. Examples of the surfactant include a cationic surfactant, an anionic surfactant, an amphoteric surfactant, and a nonionic surfactant. From the viewpoint of improving hydrophilicity, the surfactant is preferably a nonionic surfactant. From the viewpoint of improving hydrophilicity, the nonionic surfactant is preferably a polymer, more preferably an alkylene oxide polymer, and particularly preferably an ethylene oxide-propylene oxide copolymer. The alkylene oxide polymer is a polymer containing an alkyleneoxy group. The alkylene oxide polymer that is used as a surfactant can be firmly adsorbed on the solid surface that defines a flow channel, and the hydrophilic group of the alkylene oxide polymer adsorbed on the solid surface that defines a flow channel is stably disposed to face the flow channel. As a result, the alkylene oxide polymer that is used as a surfactant can not only improve the hydrophilicity but also suppress, for example, a temporal decrease in hydrophilicity. For example, the hydrophilicity of the solid surface on which the alkylene oxide polymer is adsorbed as a surfactant is unlikely to decrease even in an environment in which the speed of the fluid that flows through the flow channel is high. The alkylene oxide polymer may contain two or more kinds of alkyleneoxy groups. The alkylene oxide polymer may contain an alkyleneoxy group in the main chain, the side chain, or both the main chain and the side chain. The alkylene oxide polymer preferably contains an alkyleneoxy group in the main chain. The alkyleneoxy group may be, for example, a linear alkyleneoxy group or a branched alkyleneoxy group. The alkyleneoxy group is preferably an alkyleneoxy group having 2 to 6 carbon atoms and more preferably an alkyleneoxy group having 2 to 3 carbon atoms. Examples of the alkyleneoxy group include an ethyleneoxy group and a propyleneoxy group. The ethylene oxide-propylene oxide copolymer is a copolymer containing an ethyleneoxy group and a propyleneoxy group. In addition, from the viewpoint of utilization of the microchannel device in technical fields such as biotechnology, food, and cosmetics, the surfactant preferably has high biocompatibility. Examples of the commercially available product of the surfactant include "Pluronic" (product name, BASF SE, for example, F68 and F127).

The molecular weight of the surfactant is not limited. From the viewpoint of improving hydrophilicity, the molecular weight of the surfactant is preferably 2,000 or more, more preferably 5,000 or more, and particularly preferably 10,000 or more. From the viewpoint of the viscosity of the composition containing the surfactant that is used in the manufacturing method for a microchannel device, the molecular weight of the surfactant is preferably 100,000 or less, more preferably 50,000 or less, and particularly preferably 20,000 or less. The molecular weight of the surfactant is preferably 2,000 to 100,000, more preferably 5,000 to 50,000, and particularly preferably 10,000 to 20,000. In the present disclosure, the molecular weight of a surfactant having a molecular weight distribution shall be indicated by a weight-average molecular weight. In the present disclosure, the weight-average molecular weight is measured by gel permeation chromatography (GPC).

The amount of the surfactant adsorbed on the defining surface of the first base is indicated by the ratio of the amount of secondary ions of the surfactant to the total amount of ions detected by the time of flight secondary ion mass spectrometry (TOF-SIMS). From the viewpoint of improving hydrophilicity, the ratio of the amount of secondary ions of the surfactant adsorbed on the defining surface of the second base to the total amount of ions detected by TOF-SIMS (hereinafter, referred to as "the adsorption amount of the surfactant" in this paragraph) is preferably 0.01 or more, more preferably 0.015 or more, still more preferably 0.02 or more, and particularly preferably 0.025 or more. The upper limit of the adsorption amount of the surfactant is not limited. The upper limit of the adsorption amount of the surfactant may be, for example, 0.5, 0.3, or 0.1. The adsorption amount of the surfactant is preferably 0.01 to 0.5, more preferably 0.015 to 0.3, still more preferably 0.02 to 0.1, and particularly preferably 0.025 to 0.1.

In the present disclosure, the ratio of the amount of secondary ions of the surfactant adsorbed on a target surface to the total amount of ions detected by the time of flight secondary ion mass spectrometry (TOF-SIMS) is measured according to the following method. The relative intensity of a fragment ion (a secondary ion) specific to the surfactant, which is standardized with the intensity of total ions, is calculated by TOF-SIMS that is carried out at n = 2 according to the following conditions. The obtained value is adopted as a ratio of the amount of secondary ions of the surfactant adsorbed on the target surface to the total amount of ions detected by TOF-SIMS. In TOF-SIMS, a known time of flight mass spectrometer is used.

　　・Primary ion: $Bi_3^+$
　　・Measurement mode: Bunching Mode
　　・Measurement area: 300 $\mu$m (surface resolution: 128 × 128 pixels)
　　・Number of accumulations: 16 times
　　・Polarity: Positive

From the viewpoint of improving hydrophilicity, a contact angle of water to the region in which the surfactant is adsorbed on the defining surface of the first base (hereinafter, simply referred to as a "contact angle" in this paragraph) is preferably 60° or less, more preferably 50° or less, and particularly preferably 40° or less. The lower limit of the contact angle is not limited. The lower limit of the contact angle may be, for example, 5°, 10°, or 20°. The contact angle is preferably 5° to 60°, more preferably 5° to 50°, and particularly preferably 5° to 40°.

The defining surface of the first base may further include a region in which the surfactant is not adsorbed. In a certain embodiment, the defining surface of the first base includes a region in which the surfactant is adsorbed and a region in which the surfactant is not adsorbed. On the defining surface of the first base, the position of the region in which the surfactant is not adsorbed is not limited. The position of the region in which the surfactant is not adsorbed may be determined, for example, according to the kind of fluid. The hydrophilicity of the region in which the surfactant is not adsorbed is low as compared with the hydrophilicity of the region in which the surfactant is adsorbed. In a case of utilizing the relative difference in the hydrophilicity between the region in which the surfactant is adsorbed and the region in which the surfactant is not adsorbed, it is possible to control, for example, flow aspects of a liquid containing oil and a liquid containing water. In a fluid containing a liquid containing oil and a liquid containing water, the liquid containing oil tends to flow in the vicinity of a solid surface having low hydrophilicity. For example, in a case of joining a liquid containing oil and a liquid containing water in a flow channel defined by a solid surface having low hydrophilicity, it is possible to form water droplets. On the other hand, in a fluid containing a liquid containing oil and a liquid containing water, the liquid containing water tends to flow in the vicinity of a solid surface having high hydrophilicity. For example, in a case of joining a liquid containing oil and a liquid containing water in a flow channel defined by a solid surface having high hydrophilicity, it is possible to form oil droplets. In a case of utilizing the above-described phenomenon, it is possible to produce, for example, oil droplets that encompass water, which are dispersed in water. A system containing oil droplets that encompass water, which are dispersed in water, is referred to as a W/O/W type emulsion.

The shape of the first base is not limited. From the viewpoint of ease of manufacture, the shape of the base is preferably a flat plate.

The thickness of the first base is not limited. The thickness of the base may be determined, for example, in a range of 1 mm to 10 mm. The thickness of the base is preferably in a range of 1 mm to 10 mm, more preferably in a range of 1 mm to 5 mm, and particularly preferably in a range of 1.5 mm to 4 mm.

<<Second base>>

The microchannel device according to one embodiment of the present disclosure includes a second base that comes into contact with the first base. The second base has a defining surface that defines the flow channel together with the defining surface of the first base. The flow channel defined by the defining surface of the second base is the same as the flow channel defined by the defining surface of the first base. That is, the flow channel in the microchannel device including the first base and the second base is formed between the first base and the second base. The second base has solvent resistance. The second base having solvent resistance improves the solvent resistance of the microchannel device. Hereinafter, the second base will be specifically described.

In the present disclosure, the solvent resistance of the second base is checked according to the method shown below. Three test pieces are collected from the second base. The mass of each test piece is measured. The first test piece is immersed in methyl ethyl ketone at 25°C, the second test piece is immersed in toluene at 25°C, and the third test piece is immersed in ethyl acetate at 25°C. The mass of each test piece after the immersion for 27 days is measured. The rate of change in the mass of each test piece is determined according to the following expression. In a case where the rate of change in the mass of each test piece is within ±5%, it is determined that the second base is a base having solvent resistance.

$$\text{Expression: Rate of change in mass of test piece} = ([\text{mass of test piece before test}] - [\text{mass of test piece after test}])/[\text{mass of test piece before test}] \times 100$$

The second base preferably contains a component having solvent resistance. Examples of the component of the second base include a polymer that contains a fluorine atom, glass, and stainless steel. From the viewpoint of improving solvent resistance, the second base preferably contains at least one selected from the group consisting of a polymer that contains a fluorine atom, glass, and stainless steel.

In a certain embodiment, the second base more preferably contains a polymer that contains a fluorine atom. Since the second base including a polymer that contains a fluorine atom exhibits high affinity with respect to the first base containing a polymer that contains a fluorine atom, the bondability is improved. Examples of the polymer that contains a fluorine atom include the polymer that contains a fluorine atom, which is described in the section of "First base" described above. The preferred kind of the polymer that contains a fluorine atom is the same as the preferred kind of the polymer that contains a fluorine atom, which is described in the section of "First base" described above. The kind of the polymer that contains a fluorine atom in the second base may be the same or different from the kind of the polymer that contains a fluorine atom in the first base. From the viewpoint of improving the bondability, it is preferable that the polymer that contains a fluorine atom in the second base contains the same polymer that contains a fluorine atom as the polymer that contains a fluorine atom in the first base. The second base may include one or two or more kinds of polymers that contain a fluorine atom.

In a certain embodiment, the second base preferably contains glass. The kind of glass is not limited. The glass in the present disclosure includes known glass. Examples of the component of the glass include $Al_2O_3$, $B_2O_3$, CaO, $Na_2O$, and $SiO_2$.

In a certain embodiment, the second base preferably contains stainless steel. The kind of stainless steel is not limited. The stainless steel in the present disclosure includes known stainless steel. Examples of the stainless steel include SUS304 and SUS316. It is noted that the surface of the second base containing stainless steel may be subjected to glass-like coating with a silica sol-gel coating agent.

In the second base, the content of at least one selected from the group consisting of a polymer that contains a fluorine atom, glass, and stainless steel is not limited. In the second base, the content of at least one selected from the group consisting of a polymer that contains a fluorine atom, glass, and stainless steel is preferably 85% by mass to 100% by mass, preferably 90% by mass to 100% by mass, and particularly preferably 95% by mass to 100% by mass, with respect to the total mass of the second base from the viewpoint of improving solvent resistance. In the second base, the content of at least one selected from the group consisting of a polymer that contains a fluorine atom, glass, and stainless steel may be less than 100% by mass with respect to the total mass of the second base.

The content of the polymer that contains a fluorine atom in the second base is not limited. In a certain embodiment, the content of the polymer that contains a fluorine atom in the second base is preferably 70% by mass to 100% by mass, preferably 80% by mass to 100% by mass, and particularly preferably 90% by mass to 100% by mass, with respect to the total mass of the second base from the viewpoint of improving solvent resistance. The content of the polymer that contains a fluorine atom in the second base may be less than 100% by mass with respect to the total mass of the second base.

The content of the glass in the second base is not limited. In a certain embodiment, the content of the glass in the second base is preferably 85% by mass to 100% by mass, preferably 90% by mass to 100% by mass, and particularly preferably 95% by mass to 100% by mass, with respect to the total mass of the second base from the viewpoint of improving solvent resistance. The content of the glass in the second base may be less than 100% by mass with respect to the total mass of the second base.

The content of the stainless steel in the second base is not limited. In a certain embodiment, the content of the stainless steel in the second base is preferably 85% by mass to 100% by mass, preferably 90% by mass to 100% by mass, and particularly preferably 95% by mass to 100% by mass, with respect to the total mass of the second base from the viewpoint of improving solvent resistance. The content of the stainless steel in the second base may be less than 100% by mass with respect to the total mass of the second base.

The defining surface of the second base defines the flow channel of the microchannel device. That is, the defining surface of the second base is the surface of the second base that faces the flow channel. The number of defining surfaces of the second base is not limited. The number of defining surfaces of the second base may be one or two or more. The shape of the defining surface of the second base is not limited. The defining surface of the second base may be, for example, a flat surface or a curved surface.

In a certain embodiment, the contact angle of water on the defining surface of the second base (hereinafter, simply referred to as the "contact angle" in this paragraph) is preferably 90° or more, more preferably 95° or more, and particularly preferably 100° or more. In a case where the contact angle is 90° or more, the affinity of the liquid containing water with respect to the defining surface of the second base is decreased. The decrease in the affinity of the liquid containing water with respect to the defining surface of the second base promotes, for example, the formation of water droplets. The upper limit of the contact angle is not limited. The upper limit of the contact angle may be, for example, 140°, 130°, or 120°. The contact angle is preferably 90° to 140°, more preferably 95° to 130°, and particularly preferably 100° to 120°.

In a certain embodiment, the defining surface of the second base preferably includes a region in which a surfactant is adsorbed. That is, it is preferable that the surfactant is adsorbed to at least a part of the defining surface of the second base. The region in which the surfactant is adsorbed improves the hydrophilicity of the solid surface that defines the flow channel. The improvement of the hydrophilicity of the solid surface that defines the flow channel promotes, for example, the formation of oil droplets. On the defining surface of the second base, the position of the region in which the surfactant is adsorbed is not limited. The region on which the surfactant is adsorbed may be disposed on an entirety or a part of the defining surface of the second base. From the viewpoint of improving hydrophilicity, it is preferable that on the defining surface of the second base, the region in which the surfactant is adsorbed faces the region in which the surfactant is adsorbed, on the defining surface of the base. This is because, in one compartment of the flow channel, the greater the proportion of the region in which the surfactant is adsorbed in the solid surface that defines the flow channel is, the more the hydrophilicity of the solid surface that defines the flow channel is improved. The aspect of adsorption is not limited. The adsorption may be, for example, physical adsorption or chemical adsorption. The surfactant adsorbed on the defining surface of the second base is detected, for example, by the time of flight secondary ion mass spectrometry described above. The kind of the surfactant adsorbed on the defining surface of the second base may be one kind or two or more kinds.

Examples of the surfactant include the surfactant described in the section of "First base" described above. The preferred kind of the surfactant is the same as the preferred kind of the surfactant described in the section of "First base" described above. The kind of the surfactant adsorbed on the defining surface of the second base may be the same as or different from the kind of the surfactant adsorbed on the defining surface of the first base. It is preferable that the surfactant adsorbed on the defining surface of the second base contains the same surfactant as the surfactant adsorbed on the defining surface of the first base. The preferred molecular weight of the surfactant is the same as the preferred molecular weight of the surfactant described in the section of "First base" described above.

The amount of the surfactant adsorbed on the defining surface of the second base is indicated by the ratio of the amount of secondary ions of the surfactant to the total amount of ions detected by the time of flight secondary ion mass spectrometry (TOF-SIMS). From the viewpoint of improving hydrophilicity, the ratio of the amount of secondary ions of the surfactant adsorbed on the defining surface of the second base to the total amount of ions detected by TOF-SIMS (hereinafter, referred to as "the adsorption amount of the surfactant" in this paragraph) is preferably 0.01 or more, more preferably 0.015 or more, still more preferably 0.02 or more, and particularly preferably 0.025 or more. The upper limit of the adsorption amount of the surfactant is not limited. The upper limit of the adsorption amount of the surfactant may be, for example, 0.5, 0.3, or 0.1. The adsorption amount of the surfactant is preferably 0.01 to 0.5, more preferably 0.015 to 0.3, and particularly preferably 0.02 to 0.1.

From the viewpoint of improving hydrophilicity, a contact angle of water to the region in which the surfactant is adsorbed on the defining surface of the second base (hereinafter, simply referred to as a "contact angle" in this paragraph) is preferably 60° or less, more preferably 50° or less, and particularly preferably 40° or less. The lower limit of the contact angle is not limited. The lower limit of the contact angle may be, for example, 5°, 10°, or 20°. The contact angle is preferably 5° to 60°, more preferably 5° to 50°, and particularly preferably 5° to 40°.

The defining surface of the second base may further include a region in which the surfactant is not adsorbed. In a certain embodiment, the defining surface of the second base includes a region in which the surfactant is adsorbed and a region in which the surfactant is not adsorbed. On the defining surface of the second base, the position of the region in which the surfactant is not adsorbed is not limited. The position of the region in which the surfactant is not adsorbed may be determined, for example, according to the kind of fluid. From the viewpoint of controlling the flow aspect, it is preferable that on the defining surface of the second base, the region in which the surfactant is not adsorbed faces the region in which the surfactant is not adsorbed, on the defining surface of the base.

The shape of the second base is not limited. From the viewpoint of ease of manufacture, the shape of the second base is preferably a flat plate.

The thickness of the second base is not limited. The thickness of the second base may be determined, for example, in a range of 1 mm to 20 mm.

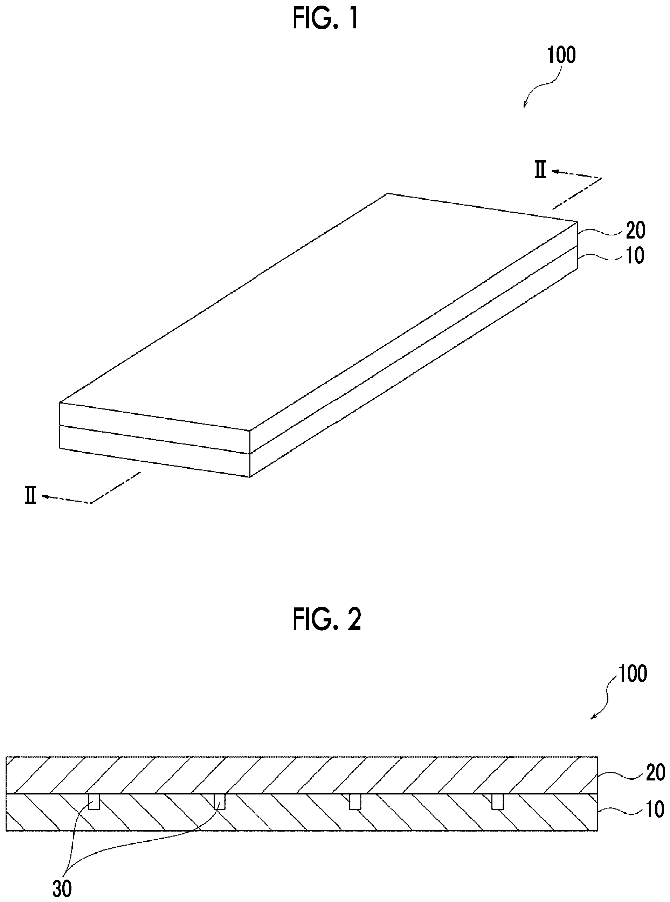

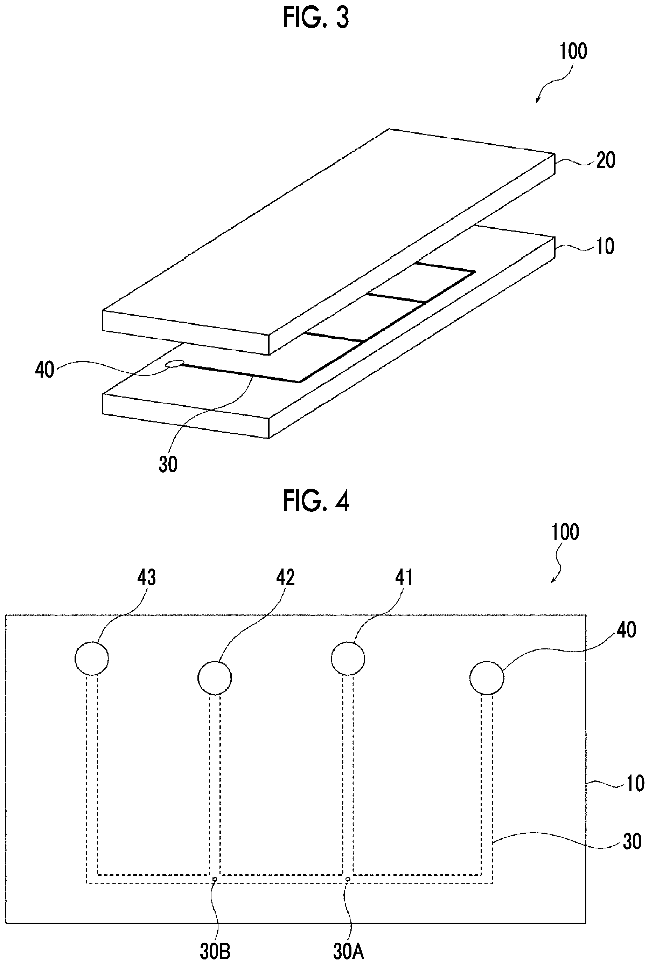

Hereinafter, a microchannel device according to a certain embodiment of the present disclosure will be described with reference to Fig. 1, Fig. 2, Fig. 3, and Fig. 4. Fig. 1 is a schematic perspective view illustrating a microchannel device according to a certain embodiment of the present disclosure. Fig. 2 is a schematic cross-sectional view taken along a line II-II illustrated in Fig. 1. Fig. 3 is a schematic exploded perspective view of the microchannel device illustrated in Fig. 1. Fig. 4 is a schematic plan view of the microchannel device illustrated in Fig. 1.

A microchannel device 100 illustrated in Fig. 1 includes a first base 10 and a second base 20. The second base 20 is disposed on the first base 10. The second base 20 is in contact with the first base 10.

As illustrated in Fig. 2 and Fig. 3, a flow channel 30 of the microchannel device 100 is formed between the first base 10 and the second base 20. As illustrated in Fig. 2, the flow channel 30 is a space surrounded by a wall surface of a groove (that is, a recessed part) formed on a surface of the first base 10 and a surface of the second base 20. The surface that surrounds the flow channel 30 is the defining surface in the present disclosure. The shape of the flow channel 30 corresponds to the shape of the groove formed on the surface of the first base 10. As illustrated in Fig. 4, the flow channel 30 is branched at a junction 30A and a junction 30B.

As illustrated in Fig. 3 and Fig. 4, the microchannel device 100 includes four opening portions that penetrate the first base 10. The four opening portions include an opening portion 40, an opening portion 41, an opening portion 42, and an opening portion 43. Each opening portion is connected to the flow channel 30. For example, the three opening portions are used as an introduction part for a fluid, and the remaining one opening portion is used as a discharge part for a fluid. As illustrated in Fig. 4, the shape of each opening portion in a case of being seen in a plan view is a circular shape. However, the shape of the opening portion in a case of being seen in a plan view is not limited to a circular shape. The dimension of each opening portion is determined in consideration of, for example, the dimension of the flow channel (for example, the width of the flow channel).

«Flow channel»

The flow channel of the microchannel device according to one embodiment of the present disclosure is defined by a defining surface of a first base and a defining surface of a second base.

The shape of the flow channel is not limited. Examples of the cross-sectional shape of the flow channel include a quadrangular shape, a circular shape, and a semi-circular shape. For example, a flow channel having a quadrangular shape in a cross section is defined by being surrounded by four plane-shaped defining surfaces. For example, a flow channel having a circular shape in a cross section is defined by being surrounded by one cylinder-shaped defining surface or two curved defining surfaces. For example, a flow channel having a semi-circular shape in a cross section is defined by being surrounded by one curved defining surface and one plane-shaped defining surface. However, the above-described specific example does not limit the relationship between the shape of the flow channel and the aspect of the defining surface (for example, the number and shape of the defining surface).

The width of the flow channel is not limited. The width of the flow channel may be determined, for example, in a range of 1 $\mu$m to 2,000 $\mu$m. The width of the flow channel is preferably in a range of 5 $\mu$m to 1,000 $\mu$m, more preferably in a range of 10 $\mu$m to 500 $\mu$m, and particularly preferably in a range of 20 $\mu$m to 400 $\mu$m.

The flow channel preferably includes a main flow channel part and at least one branch flow channel part branched from the main flow channel. In the flow channel having the above-described structure, at least two kinds of fluids can be joined at a junction of the main flow channel part with the branch flow channel part. For example, in a case of introducing a first fluid into the main flow channel part and introducing a second fluid into a first branch flow channel part branched from the main flow channel part, it is possible to join the second fluid with respect to the first fluid. For example, in a case of introducing a first fluid into the main flow channel part and introducing a second fluid into a first branch flow channel part branched from the main flow channel part, and in a case of introducing a third fluid into a second branch flow channel part branched from the main flow channel part downstream of a junction of the main flow channel part with the first branch flow channel part, it is possible to sequentially join the second fluid and the third fluid sequentially with respect to the first fluid. The number of branch flow channel parts branched from the main flow channel may be one or two or more. The number of junctions of the main flow channel part with the branch flow channel may be one or two or more. The shape of the junction of the main flow channel part with the branch flow channel is not limited. The shape of the junction of the main flow channel part with the branch flow channel may be determined, for example, according to the number of branch flow channel parts and the joining position of the branch flow channel part with respect to the main flow channel part. Examples of the shape of the junction of the main flow channel part with the branch flow channel include a T shape, a Y shape, and a cross shape.

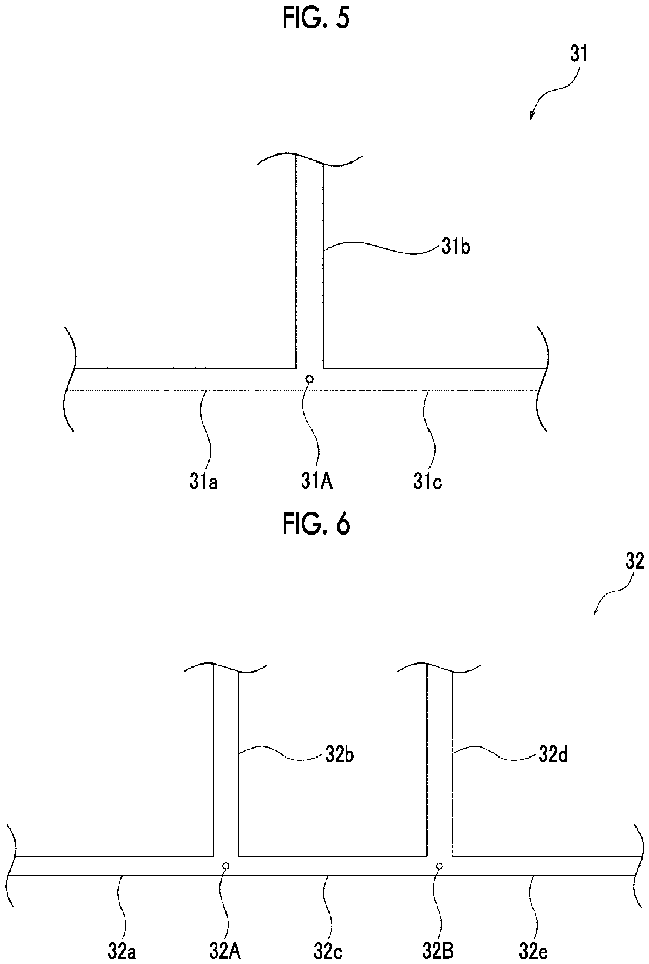

Hereinafter, the configuration of the flow channel will be described with reference to Fig. 5 and Fig. 6. Fig. 5 is a schematic plan view illustrating a flow channel of a microchannel device according to a certain embodiment of the present disclosure. Fig. 6 is a schematic plan view illustrating a flow channel of a microchannel device according to a certain embodiment of the present disclosure. However, the configuration of the flow channel is not limited to the configuration shown below.

In a certain embodiment, it is preferable that the flow channel includes a first flow channel part, a second flow channel part that joins the first flow channel part, and a third flow channel part that is connected to a junction of the first flow channel part with the second flow channel part. In the above-described embodiment, the flow channel may include, for example, four or more flow channel parts and two or more junctions.

In an example of a flow channel including such constitutional elements as described above, a flow channel 31 illustrated in Fig. 5 includes a first flow channel part 31a, a second flow channel part 31b that joins the first flow channel part 31a, and a third flow channel part 31c that is connected to a junction 31A of the first flow channel part 31a with the second flow channel part 31b. The shape of the junction 31A is a T shape.

In the flow channel 31 illustrated in Fig. 5, for example, the first fluid introduced into the first flow channel part 31a joins the second fluid introduced into the second flow channel part 31b at the junction 31A. The first fluid and the second fluid that have been joined at the junction 31A flow through the third flow channel part 31c.

For example, in a method of joining a liquid containing oil and a liquid containing water in the flow channel 31 illustrated in Fig. 5 to produce oil droplets, it is preferable that the solid surface that defines the third flow channel part 31c (preferably, the first flow channel part 31a, the second flow channel part 31b, and the third flow channel part 31c) includes a region in which the surfactant is adsorbed. The region in which the surfactant is adsorbed reduces the affinity of the liquid containing oil with respect to the solid surface that defines the flow channel and promotes the formation of oil droplets.

In a certain embodiment, it is preferable that the flow channel includes a first flow channel part, a second flow channel part that joins the first flow channel part, a third flow channel part that is connected to a junction of the first flow channel part with the second flow channel part, a fourth flow channel part that joins the third flow channel part, and a fifth flow channel part that is connected to a junction of the third flow channel part with the fourth flow channel part. In the above-described embodiment, the flow channel may include, for example, six or more flow channel parts and three or more junctions.

In an example of a flow channel including such constitutional elements as described above, a flow channel 32 illustrated in Fig. 6 includes a first flow channel part 32a, a second flow channel part 32b that joins the first flow channel part 32a, a third flow channel part 32c that is connected to a junction 32A of the first flow channel part 32a with the second flow channel part 32b, a fourth flow channel part 32d that joins the third flow channel part 32c, and a fifth flow channel part 32e that is connected to a junction 32B of the third flow channel part 32c with the fourth flow channel part 32d. The shape of the junction 32A is a T shape. The shape of the junction 32B is a T shape.

In the flow channel 32 illustrated in Fig. 6, for example, the first fluid introduced into the first flow channel part 32a joins the second fluid introduced into the second flow channel part 32b at the junction 32A. The first fluid and the second fluid that have been joined at the junction 32A go through the third flow channel part 32c and join the third fluid introduced into the fifth flow channel part 32e at the junction 32B. The first fluid, the second fluid, and the third fluid that have been joined at the junction 32B flow through the fourth flow channel part 32d.

For example, in a method of joining a liquid containing oil as the first fluid, a liquid containing water as the second fluid, and a liquid containing water as the third fluid in the flow channel 32 illustrated in Fig. 6 to produce a W/O/W type emulsion (that is, a system containing oil droplets that encompass water, which are dispersed in water), it is preferable that the solid surface that defines the first flow channel part 32a and the second flow channel part 32b include a region in which the surfactant is not adsorbed. In addition, the solid surface that defines the third flow channel part 32c may include a region in which the surfactant is not adsorbed. The region in which the surfactant is not adsorbed reduces the affinity of the liquid containing water with respect to the solid surface that defines the flow channel and promotes the formation of water droplets. Further, it is preferable that the solid surface that defines the fourth flow channel part 32d and the fifth flow channel part 32e include a region in which the surfactant is adsorbed. The region in which the surfactant is adsorbed reduces the affinity of the liquid containing oil with respect to the solid surface that defines the flow channel and promotes the formation of oil droplets. For example, by utilizing the above-described characteristics, in a case of joining the first fluid (the liquid containing oil) introduced into the first flow channel part 32a, the second fluid (the liquid containing water) introduced into the second flow channel part 32b, and the third fluid (the liquid containing water) introduced into the fifth flow channel part 32e, the water in the second fluid (the liquid containing water) undergoes a process of being covered with the oil in the first fluid (the liquid containing oil) and then the water in the third fluid (the liquid containing water), whereby a W/O/W type emulsion is obtained.

«Use application»

The use application of the microchannel device according to one embodiment of the present disclosure is not limited. The microchannel device according to one embodiment of the present disclosure may be utilized, for example, for mixing, separation, analysis, or reaction. The microchannel device according to one embodiment of the present disclosure is preferably used in a technique of using a liquid containing oil. Specific examples of the use application of the microchannel device according to one embodiment of the present disclosure are shown below. However, the use application of the microchannel device according to one embodiment of the present disclosure is not limited to the specific examples shown below.

[Production of liquid droplet]

The microchannel device according to one embodiment of the present disclosure is preferably used for producing liquid droplets. Examples of the liquid droplet include an oil droplet and a water droplet. Examples of the oil droplet include an oil droplet dispersed in water. The oil droplet may encompass, for example, water or air. Examples of the water droplet include water droplets dispersed in oil. The water droplet may encompass, for example, oil or air. The liquid droplets are produced, for example, by joining a liquid containing oil and a liquid containing water in the flow channel of the microchannel device. The liquid droplet may be produced with reference to, for example, a production method for a liquid droplet using a known microchannel device. Hereinafter, a production method for a liquid droplet using the microchannel device according to one embodiment of the present disclosure will be described.
The production method for a liquid droplet according to one embodiment of the present disclosure is a production method for a liquid droplet using the microchannel device according to one embodiment of the present disclosure. It is preferable that the production method for a liquid droplet according to one embodiment of the present disclosure includes joining a liquid containing oil and a liquid containing water in the flow channel of the microchannel device to obtain the liquid droplet.
The oil in the present disclosure includes a liquid that is immiscible with water. Examples of the oil include fluorine oil, silicone oil, and mineral oil. Examples of the commercially available product of fluorine oil include "NOVEC 7300" (manufactured by 3M Company). In addition, examples of the commercially available silicone oil include "KF96-1CS" (Shin-Etsu Chemical Co., Ltd.). The liquid containing oil may contain two or more kinds of oils. The liquid containing oil may contain a component other than oil. It is preferable that the liquid containing oil contains, for example, at least one selected from the group consisting of a surfactant and a lipophilic polymer, which are for improving the formability of water droplets and the stability of the formed water droplets. Furthermore, the liquid containing oil may contain fine particles or water droplets, depending on the use application.
Examples of water include pure water. The liquid containing water may contain a component other than water. It is preferable that the liquid containing water contains, for example, at least one selected from the group consisting of a surfactant and a hydrophilic polymer, which are for improving the formability of oil droplets and the stability of the formed oil droplets. Furthermore, the liquid containing water may contain fine particles or oil droplets, depending on the use application.

Examples of a method of feeding a liquid into the flow channel of the microchannel device include a method using a liquid feeding pump. The kind of liquid feeding pump is not limited. The kind of liquid feeding pump may be determined, for example, according to the kind of the liquid and the amount of the liquid to be fed. Examples of the liquid feeding pump include a syringe pump, a plunger pump, a mono pump, a diaphragm pump, a tubing pump, and a pneumatic pump. From the viewpoint of low pulsation at the time of liquid feeding, a syringe pump, a pneumatic pump, a multiple plunger pump, or a mono pump is preferable.

Examples of a method of joining a liquid containing oil and a liquid containing water include a method of joining a liquid containing oil and a liquid containing water in a flow channel including a main flow channel part and at least one branch flow channel part branched from the main flow channel. In the production method for a liquid droplet, for example, a flow channel including constitutional elements as illustrated in Fig. 5 is used. For example, in a case of joining a liquid containing oil and a liquid containing water in the flow channel 31 illustrated in Fig. 5, the liquid containing oil, which flows through the second flow channel part 31b, joins the liquid containing water, which flows through the first flow channel part 31a at the junction 31A, whereby liquid droplets are formed.

The affinity of the liquid with respect to the solid surface that defines the flow channel affects the kind of liquid droplet formed by the joining of a liquid containing oil to join a liquid containing water. For example, in a case of joining a liquid containing oil and a liquid containing water in a flow channel defined by a solid surface having high hydrophilicity, oil droplets are formed. On the other hand, in a case of joining a liquid containing oil and a liquid containing water in a flow channel defined by a solid surface having low hydrophilicity, water droplets are formed.

[Production of air bubble]

The microchannel device according to one embodiment of the present disclosure is preferably used for producing air bubbles. Examples of the air bubble include air bubbles dispersed in oil and air bubbles dispersed in water. The air bubbles are produced, for example, by joining a liquid and a gas in the flow channel of the microchannel device. The air bubble may be produced with reference to, for example, a production method for an air bubble using a known microchannel device. Hereinafter, a production method for a gas using the microchannel device according to one embodiment of the present disclosure will be described.

The production method for an air bubble according to one embodiment of the present disclosure is a production method for an air bubble using the microchannel device according to one embodiment of the present disclosure. It is preferable that the production method for an air bubble according to one embodiment of the present disclosure includes joining a liquid and a gas in the flow channel of the microchannel device to obtain the air bubble.

Examples of the liquid include a liquid containing oil and a liquid containing water. The oil is as described in the section of "Production of liquid droplet" described above. The liquid containing oil may contain two or more kinds of oils. The liquid containing oil may contain a component other than oil. The water is as described in the section of "Production of liquid droplet" described above. The liquid containing water may contain a component other than water. The liquid feeding method is as described in the section of "Production of liquid droplet" described above.

Examples of the gas include oxygen, nitrogen, a mixture of oxygen and nitrogen, and nitrogen containing a trace amount of a volatile component of fluorine oil.

Examples of a method of joining a liquid and a gas include a method of joining a liquid and a gas in a flow channel including a main flow channel part and at least one branch flow channel part branched from the main flow channel. In the production method for an air bubble, for example, a flow channel including constitutional elements as illustrated in Fig. 5 is used. For example, in a case of joining a liquid and a gas in the flow channel 31 illustrated in Fig. 5, the liquid which flows through the second flow channel part 31b, joins the gas which flows through the first flow channel part 31a at the junction 31A, whereby air bubbles are formed.

[Production of microcapsule]

The microchannel device according to one embodiment of the present disclosure is preferably used for producing microcapsules. The kind of microcapsule is not limited. The microcapsule may be, for example, a multiple microcapsule. The microcapsule includes, for example, a core material and an outer shell that encompasses the core material.

The kind of core material is not limited. Examples of the substance encompassed by the microcapsule include an organic compound and a solvent. Examples of the organic compound include a flavoring agent, a dye, and a phase change material. Examples of the solvent include water and an organic solvent.

The component of the outer shell of the microcapsule is not limited. Examples of the component of the outer shell of the microcapsule include a polymer. Examples of the polymer include polyurethane, polyurea, polyester, polyether, polyolefin, polyamide, polyvinyl chloride, and an acrylic resin.

The microcapsule is produced, for example, by joining a liquid containing oil and a liquid containing water in the flow channel of the microchannel device. The microcapsule may be produced with reference to, for example, a production method for a microcapsule using a known microchannel device. Hereinafter, a production method for a microcapsule using the microchannel device according to one embodiment of the present disclosure will be described.

The production method for a microcapsule according to one embodiment of the present disclosure is a production method for a microcapsule using the microchannel device according to one embodiment of the present disclosure. It is preferable that the production method for a microcapsule according to one embodiment of the present disclosure includes joining a liquid containing oil and a liquid containing water in the flow channel of the microchannel device to obtain the microcapsule. In a certain embodiment, the microcapsule is preferably formed by a polymerization method. According to the polymerization method, the outer shell of the microcapsule is formed, for example, by a polymerization reaction that proceeds at an interface between a liquid containing oil and a liquid containing water, which have been joined with each other. Examples of the polymerization method include an in situ polymerization method and an interfacial polymerization method. In addition, in a production method for a microcapsule according to another embodiment of the present disclosure, it is also possible to irradiate oil droplets with heat or light in the microchannel device or outside the microchannel device after producing the oil droplets in the flow channel of the microchannel device, thereby polymerizing a polymerizable compound (for example, a monomer) that is contained in the liquid containing oil, the liquid containing water, or both the liquid containing oil and the liquid containing water.

The oil is as described in the section of "Production of liquid droplet" described above. The liquid containing oil may contain a component other than oil. The liquid containing oil preferably contains at least one selected from the group consisting of a monomer and a polymerization initiator.

The water is as described in the section of "Production of liquid droplet" described above. The liquid containing water may contain a component other than water. The liquid containing water preferably contains at least one selected from the group consisting of a monomer and a polymerization initiator.

The liquid feeding method is as described in the section of "Production of liquid droplet" described above.

The method of joining a liquid containing oil and a liquid containing water is as described in the section of "Production of liquid droplet" described above. In the production method for a microcapsule, for example, a flow channel including constitutional elements as illustrated in Fig. 5 is used.

In the production method for a multiple microcapsule, the multiple microcapsule is produced, for example, by adjusting the kinds of the liquid to be joined in the flow channel and the joining timing of the liquid according to the configuration of the targeted multiple microcapsule.

[Production of multiple emulsion]

The microchannel device according to one embodiment of the present disclosure is preferably used for producing a multiple emulsion. Examples of the multiple emulsion include a W/O/W type emulsion and an O/W/O type emulsion. The W/O/W type emulsion is a system containing oil droplets that encompass water, where the oil droplets are dispersed in water. The O/W/O type emulsion is a system containing water droplets that encompass oil, where the water droplets are dispersed in oil. In the multiple emulsion, the number of layers contained in the liquid droplets dispersed in the dispersion medium may be, for example, two layers or three or more layers. The dispersion medium is also referred to as a continuous phase.

The multiple emulsion is produced, for example, by joining at least three liquids in the flow channel of the microchannel device. The multiple emulsion may be produced with reference to, for example, a production method for a multiple emulsion using a known microchannel device. Hereinafter, a production method for a multiple emulsion using the microchannel device according to one embodiment of the present disclosure will be described.

The production method for a multiple emulsion according to one embodiment of the present disclosure is a production method for a multiple emulsion using the microchannel device according to one embodiment of the present disclosure. It is preferable that the production method for a multiple emulsion according to one embodiment of the present disclosure includes joining at least three liquids in the flow channel of the microchannel device to obtain the multiple emulsion.

Examples of the liquid include a liquid containing oil and a liquid containing water. The oil is as described in the section of "Production of liquid droplet" described above. The liquid containing oil may contain two or more kinds of oils. The liquid containing oil may contain a component other than oil. The water is as described in the section of "Production of liquid droplet" described above. The liquid containing water may contain a component other than water. The liquid feeding method is as described in the section of "Production of liquid droplet" described above.

Examples of a method of joining at least three liquids include a method of joining at least three liquids in a flow channel including a main flow channel part and at least two branch flow channel parts branched from the main flow channel. The multiple emulsion is produced, for example, by adjusting the kinds of the liquid to be joined in the flow channel and the joining timing of the liquid according to the configuration of the targeted multiple emulsion. In the production method for a multiple emulsion, for example, a flow channel including constitutional elements as illustrated in Fig. 6 is used.

Hereinafter, a production method for a W/O/W type emulsion, which is an example of the multiple emulsion, will be described. In the production method for a W/O/W type emulsion, at least three kinds of liquids include a first liquid containing oil, a second liquid containing water, and a third liquid containing water. The W/O/W type emulsion is obtained, for example, by joining the first liquid containing oil and the second liquid containing water in the flow channel of the microchannel device and then joining the obtained mixture and the third liquid containing water. In the W/O/W type emulsion, the water contained in the second liquid is encompassed in oil droplets dispersed in the dispersion medium. In the W/O/W type emulsion, the oil droplets are formed by the oil contained in the first liquid. In the W/O/W type emulsion, the dispersion medium is formed by the water contained in the third liquid.

[Production of liquid droplet that encompasses air bubble]

The microchannel device according to one embodiment of the present disclosure is preferably used for producing liquid droplets that encompass air bubbles. Examples of the liquid droplet that encompasses air bubbles include liquid droplets that encompass air bubbles, which are dispersed in a liquid. Examples of the liquid that is used as the dispersion medium include oil and water. Examples of the liquid droplet include an oil droplet and a water droplet. The liquid droplet is preferably an oil droplet. In a case where the liquid droplet is an oil droplet, the liquid that is used as a dispersion medium is preferably water. The liquid droplets that encompass air bubbles are produced, for example, by joining a gas, a liquid containing oil, and a liquid containing water in the flow channel of the microchannel device. The liquid droplet that encompasses air bubbles may be produced with reference to, for example, a production method for an oil droplet using a known microchannel device. Hereinafter, a production method for a liquid droplet that encompasses air bubbles, using the microchannel device according to one embodiment of the present disclosure, will be described.

The production method for a liquid droplet that encompasses air bubbles according to one embodiment of the present disclosure is a production method for a liquid droplet that encompasses air bubbles using the microchannel device according to one embodiment of the present disclosure. It is preferable that the production method for a liquid droplet that encompasses air bubbles according to one embodiment of the present disclosure includes joining a gas, a liquid containing oil, and a liquid containing water in the flow channel of the microchannel device to obtain the liquid droplet that encompasses air bubbles.

The oil is as described in the section of "Production of liquid droplet" described above. The liquid containing oil may contain two or more kinds of oils. The liquid containing oil may contain a component other than oil.

The water is as described in the section of "Production of liquid droplet" described above. The liquid containing water may contain a component other than water. It is noted that in a case where two or more water phases are generated in the liquid droplet that encompasses air bubbles, the liquid containing water preferably contains a salt for adjusting the osmotic pressure in order to suppress the destabilization of the liquid droplet due to the osmotic pressure with the oil phase being sandwiched between at least two water phases.

The liquid feeding method is as described in the section of "Production of liquid droplet" described above.

The gas is as described in the section of "Production of liquid droplet" described above.

Examples of a method of joining a gas, a liquid containing oil, and a liquid containing water include a method of joining a gas, a liquid containing oil, and a liquid containing water in a flow channel including a main flow channel part and at least two branch flow channel parts branched from the main flow channel. In the production method for a liquid droplet that encompasses air bubbles, for example, a flow channel including constitutional elements as illustrated in Fig. 6 is used.

The affinity of the liquid with respect to the solid surface that defines the flow channel affects the kind of liquid droplet formed by the joining of a liquid containing oil to join a liquid containing water. For example, in a case of joining a liquid containing oil and a liquid containing water in a flow channel defined by a solid surface having high hydrophilicity, oil droplets are formed. On the other hand, in a case of joining a liquid containing oil and a liquid containing water in a flow channel defined by a solid surface having low hydrophilicity, water droplets are formed.

[Another use application]

The microchannel device according to one embodiment of the present disclosure may be used for a use application other than the above-described use applications. The microchannel device according to one embodiment of the present disclosure may be used for producing particles having a multilayer structure, such as Janus particles or partial microcapsules in which a part of the multiplexed structure is a solid.

[Flow aspect]

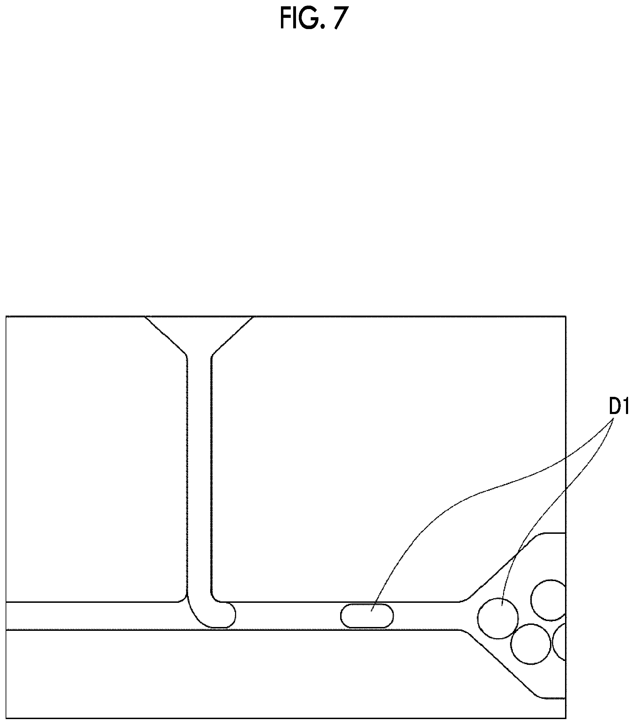

The formation of the liquid droplet will be described with reference to Fig. 7. Fig. 7 is a schematic plan view illustrating a flow aspect of a fluid in a flow channel of a microchannel device according to a certain embodiment of the present disclosure. As illustrated in Fig. 7, a liquid droplet D1 is formed, for example, in a case where two liquids are joined at a T-shaped junction in the flow channel.

<<Manufacturing method for microchannel device>>

It is preferable that a manufacturing method for a microchannel device according to one embodiment of the present disclosure includes (1) preparing a first base having a surface that has a groove and containing a polymer that contains a fluorine atom, (2) subjecting the surface of the first base to a plasma treatment in a presence of an ammonia gas, (3) preparing a second base having a surface for coming into contact with the first base and having solvent resistance, (4) subjecting the surface of the second base to a plasma treatment in a presence of an ammonia gas, and (5) bringing the surface of the second base, subjected to the plasma treatment, into contact with the surface of the first base, subjected to the plasma treatment, to form a flow channel defined by the first base and the second base. Hereinafter, each stage of the manufacturing method for a microchannel device will be specifically described.

[Step (1)]

In the step (1), a first base having a surface that has a groove and containing a polymer that contains a fluorine atom is prepared. Hereinafter, a surface that has a groove in the first base may be referred to as a "specific surface of the first base".
Examples of the polymer that contains a fluorine atom include the polymer that contains a fluorine atom, which is described in the section of "First base" described above. The preferred kind of the polymer that contains a fluorine atom is the same as the preferred kind of the polymer that contains a fluorine atom, which is described in the section of "First base" described above.
The specific surface of the first base includes a region that comes into contact with the second base in the step (5) described later and a region that defines a flow channel that is formed in the step (5) described later. The specific surface of the first base is subjected to a plasma treatment in the step (2) described later and then is brought into contact with the second base in the step (5) described later. The shape of the groove is not limited. The shape of the groove is determined, for example, according to the shape of the target flow channel. Examples of the cross-sectional shape of the groove include a quadrangular shape and a semi-circular shape. The method of forming the groove is not limited. Examples of the method for forming the groove include a method using a mold produced by photolithography. A large number of flow channels of known microchannel devices are formed, for example, by using a mold produced by photolithography. The first base having a groove is obtained, for example, by bringing a silicone or a composition containing a silicone material into contact with a mold produced by photolithography and then curing the composition. The shape of the protruding part of the mold corresponds to, for example, the shape of the groove (that is, the recessed part) of the first base.
The shape of the first base is not limited. From the viewpoint of ease of manufacture, the shape of the first base is preferably a flat plate. For example, the flat plate-shaped first base has a first main surface and a second main surface on a side opposite to the first main surface. In the flat plate-shaped first base, the specific surface of the first base may be the first main surface or the second main surface.

[Step (2)]

In the step (2), the specific surface of the first base is subjected to a plasma treatment (hereinafter, may be referred to as a "first plasma treatment" in this section) in the presence of the ammonia gas. In the step (2), a portion that comes into contact with a composition containing a surfactant described later may be also subjected to a plasma treatment, as necessary. In the first plasma treatment, a functional group such as an $-NH_3$ group is formed on the specific surface of the first base. The functional group such as an $-NH_3$ group formed on the specific surface of the first base improves the adhesiveness of the first base to the second base in the step (5) described later. In the plasma treatment, for example, a known plasma treatment apparatus may be used. The gas that is used in the first plasma treatment may contain a gas other than the ammonia gas as long as the gist of the present disclosure is maintained.
The flow rate of the ammonia gas in the first plasma treatment is preferably 1 sccm to 500 sccm, more preferably 10 sccm to 300 sccm, and particularly preferably 50 sccm to 150 sccm.
The pressure in the first plasma treatment is preferably 10 Pa to 300 Pa, more preferably 20 Pa to 200 Pa, and particularly preferably 50 Pa to 150 Pa.
The treatment time in the first plasma treatment is preferably 30 seconds to 700 seconds, more preferably 50 seconds to 500 seconds, and particularly preferably 100 seconds to 300 seconds.
The output in the first plasma treatment is preferably 10 W to 1,000 W, more preferably 20 W to 500 W, and particularly preferably 50 W to 150 W. The output is a radio frequency (RF) output.

The manufacturing method for a microchannel device according to one embodiment of the present disclosure may include, after the first plasma treatment, subjecting the specific surface of the first base to a plasma treatment (hereinafter, may be referred to as a "second plasma treatment" in this section) in the presence of the oxygen gas. In the second plasma treatment, functional groups such as an -OH group and a -COOH group are formed on the specific surface of the first base. The functional groups such as an -OH group and a -COOH group formed on the specific surface of the first base improve the hydrophilicity of the specific surface of the first base. As a result, the hydrophilicity of the defining surface of the first base is improved. The gas that is used in the second plasma treatment may contain a gas other than the oxygen gas as long as the gist of the present disclosure is maintained.

The flow rate of the oxygen gas in the second plasma treatment is preferably 1 sccm to 500 sccm, more preferably 10 sccm to 500 sccm, and particularly preferably 50 sccm to 150 sccm.

The pressure in the second plasma treatment is preferably 10 Pa to 300 Pa, more preferably 20 Pa to 200 Pa, and particularly preferably 50 Pa to 150 Pa.

The treatment time in the second plasma treatment is preferably 10 seconds to 500 seconds, more preferably 20 seconds to 300 seconds, and particularly preferably 50 seconds to 150 seconds.

The output in the second plasma treatment is preferably 10 W to 1,000 W, more preferably 15 W to 700 W, and particularly preferably 50 W to 500 W. The output is a radio frequency (RF) output.

The manufacturing method for a microchannel device according to one embodiment of the present disclosure may include, after the second plasma treatment, subjecting the specific surface of the first base to a plasma treatment (hereinafter, may be referred to as a "third plasma treatment" in this section) in the presence of the ammonia gas. In the third plasma treatment, a functional group such as an $-NH_3$ group is further formed on the specific surface of the first base, on which functional groups such as an -OH group and a -COOH group have been formed through the second plasma treatment. The series of plasma treatments including the first plasma treatment, the second plasma treatment, and the third plasma treatment, improves the hydrophilicity of the specific surface of the first base and the adhesiveness of the first base to the second base in the step (5) described later. The gas that is used in the third plasma treatment may contain a gas other than the ammonia gas as long as the gist of the present disclosure is maintained.

The flow rate of the ammonia gas in the third plasma treatment is preferably 1 sccm to 500 sccm, more preferably 10 sccm to 300 sccm, and particularly preferably 50 sccm to 150 sccm.

The pressure in the third plasma treatment is preferably 10 Pa to 300 Pa, more preferably 20 Pa to 200 Pa, and particularly preferably 50 Pa to 150 Pa.

The treatment time in the third plasma treatment is preferably 30 seconds to 700 seconds, more preferably 50 seconds to 500 seconds, and particularly preferably 100 seconds to 300 seconds.

The output in the third plasma treatment is preferably 10 W to 1,000 W, more preferably 20 W to 500 W, and particularly preferably 50 W to 150 W. The output is a radio frequency (RF) output.

[Step (3)]

In the step (3), a second base having a surface for being in contact with the first base is prepared, where the second base has solvent resistance. Hereinafter, a surface of the second base, which is for coming into contact with the first base, may be referred to as a "specific surface of the second base".

Examples of the component of the second base include the component described in the section of "Second base (second base)" described above. The preferred component of the second base is the same as the preferred component of the second base, which is described in the section of "Second base (second base)" described above.

The specific surface of the second base is subjected to a plasma treatment in the step (4) described later and then is brought into contact with the first base in the step (5) described later. A groove may be formed on the specific surface of the second base. The shape of the groove is not limited. The shape of the groove is determined, for example, according to the shape of the target flow channel. Examples of the cross-sectional shape of the groove include a quadrangular shape and a semi-circular shape. Examples of the method for forming the groove include a method using a mold produced by photolithography described in the section of "Step (1)" described above.

The shape of the second base is not limited. From the viewpoint of ease of manufacture, the shape of the second base is preferably a flat plate. For example, the flat plate-shaped second base has a first main surface and a second main surface on a side opposite to the first main surface. In the flat plate-shaped second base, the specific surface of the second base may be the first main surface or the second main surface.

[Step (4)]

In the step (4), the specific surface of the second base is subjected to a plasma treatment (hereinafter, may be referred to as a "first plasma treatment" in this section) in the presence of the ammonia gas. In the step (4), a portion that comes into contact with a composition containing a surfactant described later may be also subjected to a plasma treatment, as necessary. The preferred conditions for the first plasma treatment are the same as the preferred conditions for the first plasma treatment described in the section of "Step (2)" described above.

The manufacturing method for a microchannel device according to one embodiment of the present disclosure may include, after the first plasma treatment, subjecting the specific surface of the second base to a plasma treatment (hereinafter, may be referred to as a "second plasma treatment" in this section) in the presence of the oxygen gas. The preferred conditions for the second plasma treatment are the same as the preferred conditions for the second plasma treatment described in the section of "Step (2)" described above.

The manufacturing method for a microchannel device according to one embodiment of the present disclosure may include, after the second plasma treatment, subjecting the specific surface of the second base to a plasma treatment (hereinafter, may be referred to as a "third plasma treatment" in this section) in the presence of the ammonia gas. The preferred conditions for the second plasma treatment are the same as the preferred conditions for the second plasma treatment described in the section of "Step (2)" described above.

It is preferable that the step (4) and the step (2) are carried out at the same time. That is, in the step (4), it is preferable that the specific surface of the first base and the specific surface of the second base are subjected the plasma treatment at the same time. In a case of carrying out the step (2) and the step (4) at the same time, the time taken from the end of the step (2) and the step (4) to the start of the step (5) is shortened, and in the step (5) described later, the adhesiveness between the first base and the second base is improved. The step (2) and the step (4) may be carried out at the same time in, for example, one plasma treatment apparatus.

[Step (5)]

In the step (5), the specific surface of the second base, which has been subjected to the plasma treatment, is brought into contact with the specific surface of the first base, which has been subjected to the plasma treatment, to form a flow channel defined by the first base and the second base. After the plasma treatment, the second base is brought into contact with the first base, whereby the second base is adhered to the first base. In the step (5), the groove of the first base is covered with the second base, whereby a space (that is, a flow channel) surrounded by the surface of the first base and the surface of the second base is formed.

From the viewpoint of improving the bondability, the time taken from the end of the plasma treatment to the bringing of the specific surface of the second base, subjected to the plasma treatment, into contact with the specific surface of the first base, subjected to the plasma treatment, (hereinafter, referred to as a "waiting time" in the present paragraph) is preferably 0.5 minutes to 10 minutes, more preferably 0.5 minutes to 8 minutes, and preferably 0.5 minutes to 5 minutes. In a case where the manufacturing method for a microchannel device according to one embodiment of the present disclosure includes a plurality of plasma treatments which are carried out at different timing, the waiting time is counted from the end of the last plasma treatment.

From the viewpoint of improving the bondability, it is preferable that in the step (5), a load is applied to the first base and the second base after the specific surface of the second base is brought into contact with the specific surface of the first base. The load may be determined depending on, for example, the component of the base. The load is preferably 50 g/cm$^2$ to 500 g/cm$^2$ and more preferably 80 g/cm$^2$ to 300 g/cm$^2$. From the viewpoint of improving the bondability, it is more preferable that in the step (5), after the specific surface of the second base is brought into contact with the specific surface of the first base under a temperature condition described later, a load is applied to the first base and the second base.

From the viewpoint of improving the bondability, in the step (5), the first base and the second base may be heated after the specific surface of the second base is brought into contact with the specific surface of the first base. The temperature may be determined depending on, for example, the component of the base. The temperature is preferably 50°C to 300°C, more preferably 80°C to 300°C, and particularly preferably 120°C to 300°C. The temperature in a heating method using a non-contact type heating device indicates the ambient temperature. The temperature in a heating method using a contact type heating device indicates the temperature of an article that comes into direct contact with the base.

[Step (6)]

The manufacturing method for a microchannel device according to one embodiment of the present disclosure may include causing a composition containing a surfactant to flow into the flow channel formed through the step (5) described above. In a case of causing a composition containing a surfactant to flow into the flow channel, it is possible to adsorb a surfactant to a portion of the solid surface that defines the flow channel (that is, the defining surface of the first base and the defining surface of the second base), where the portion comes into contact with the composition.

Examples of the surfactant include the surfactant described in the section of "First base" described above. The preferred kind of the surfactant is the same as the preferred kind of the surfactant described in the section of "First base" described above. The composition may contain two or more kinds of surfactants.

The content of the surfactant in the composition is preferably 0.1% by mass to 20% by mass, more preferably 0.5% by mass to 15% by mass, and particularly preferably 2% by mass to 8% by mass, with respect to the total mass of the composition.

The composition containing a surfactant is produced, for example, by mixing a surfactant and a solvent. The solvent is preferably a solvent that does not dissolve the first base and the second base. The solvent is preferably water.

The method of causing the composition to flow into the flow channel is not limited. The composition may be caused to flow into the flow channel by, for example, a method using a liquid feeding pump or an immersion method. The liquid feeding pump is as described in the section of "Production of liquid droplet" described above. In the immersion method, the first base and the second base bonded to each other in the step (5) are immersed in a composition, to cause a composition containing a surfactant to flow through the flow channel by a capillary force.

In a method using a liquid feeding means such as a liquid feeding pump, the flow rate of the composition is preferably 0.1 mm/sec to 1,000 mm/sec, more preferably 0.5 mm/sec to 500 mm/sec, and particularly preferably 1 mm/sec to 100 mm/sec. In a case where the flow rate of the composition is 0.1 mm/sec or more, the uniformity of the hydrophilization treatment is improved. In a case where the flow rate of the composition is 1,000 mm/sec or less, the adsorptivity of the surfactant to the first base and the second base is improved.

The flow time of the composition is preferably 0.5 minutes to 120 minutes, more preferably 1 minute to 60 minutes, and particularly preferably 2 minutes to 30 minutes. In the immersion method, the flow time is indicated by the immersion time.

The amount of the surfactant adsorbed on the solid surface that defines the flow channel is adjusted, for example, by the content of the surfactant in the composition, the flow rate of the composition, or the flow time of the composition.

The step (6) may be carried out a plurality of times. For example, in a case where the step (6) is carried out a plurality of times, the step (5) may be further carried out after the n-th step (6) and before the n + 1-th step (6). Further, after the step (6), the step (5) may be further carried out. In a case where the step (5) is further carried out at such timing as described above, the bondability is improved. It is preferable that the step (5) carried out at such timing as described above is carried out under a condition of pressurization or heating, or both conditions of pressurization and heating. The heating condition and the pressurizing condition in the step (5) are as described in the section of "Step (5)" described above.

In the step (6), in order to introduce a composition into the flow channel, an opening portion that is connected to the flow channel may be formed in the microchannel device, as necessary. In the step prior to the step (6), the opening portion may be formed in the first base or the second base.

Examples

Hereinafter, the present disclosure will be described in detail according to Examples. However, the present disclosure is not limited to the following Examples.

<Example 1>

A microchannel device was produced according to the following procedure. The microchannel device includes a first base and a second base that comes into contact with the base (see, for example, Fig. 1).

(Step 1: Preparation of photo mask)

A photo mask (System Advance Co., Ltd.) including a blue plate glass and a patterned chromium thin film was prepared. One surface of the blue plate glass (hereinafter, referred to as a "first surface") is covered with a patterned chromium thin film. A region of the first surface of the blue plate glass, which is covered with the patterned chromium thin film, forms a light shielding part of the photo mask. A region of the first surface of the blue plate glass, which is not covered with the patterned chromium thin film, forms a transmissive part of the photo mask. The photo mask includes a T-shaped transmissive part. The line width of the T-shaped transmissive part is 300 μm.

(Step 2: Production of mold)

A 4-inch silicon wafer (ELECTRONICS AND MATERIALS CORPORATION LIMITED) was washed with acetone and ethanol. The washed silicon wafer was dried at 100°C for 10 minutes using a hot plate (HP-1SA, AS ONE Corporation). The dried silicon wafer was placed on a spin coater (MS-A150, Mikasa Co., Ltd.) by suction. 5 mL of "SU-8 3050" (KAYAKU Advanced Materials, Inc.) was dropwise added onto the silicon wafer. "SU-8 3050" is a negative tone photoresist. After removing air bubbles in the "SU-8 3050" dropwise added onto the silicon wafer, the silicon wafer was rotated at a rotation speed of 1,300 revolutions per minute (rpm) for 30 seconds. The silicon wafer covered with a thin film of "SU-8 3050" was subjected to prebaking at 65°C for 5 minutes and at 95°C for 40 minutes, and then the silicon wafer was cooled to room temperature. The silicon wafer was placed on a mask aligner by suction. A chromium thin film of the photo mask was brought into contact with the thin film of "SU-8 3050", formed on the silicon wafer, and the thin film of "SU-8 3050" was irradiated with ultraviolet rays of 8.0 mW/cm$^2$ (wavelength: 365 nm) for 25 seconds. The silicon wafer was subjected to baking at 65°C for 1 minute and then at 95°C for 15 minutes, and then the silicon wafer was cooled to room temperature. The silicon wafer and 10 mL of "SU-8 developer" (KAYAKU Advanced Materials, Inc.) were placed in a glass petri dish having a diameter of 120 mm and then subjected to development for 10 minutes by using a shaker (NR-10, TAITEC CORPORATION, shaking speed: 30 rpm). "SU-8 3050" and "SU-8 developer", remaining on the silicon wafer, were washed with isopropyl alcohol (FUJIFILM Wako Pure Chemical Corporation). The silicon wafer was subjected to hard baking at 150°C for 20 minutes by using a hot plate. A mold was obtained according to the above procedure. The mold includes the silicon wafer and a pattern formed on the silicon wafer by using the photoresist.

(Step 3: Production of first base)

The mold was washed with acetone and ethanol and then dried at 100°C for 10 minutes by using a hot plate. On the mold placed in the glass petri dish, a composition obtained by mixing X-71C-8115A (a fluorine elastomer, "SHIN-ETSU SIFEL", Shin-Etsu Chemical Co., Ltd.) and X-71C-8115B (a fluorine elastomer, "SHIN-ETSU SIFEL", Shin-Etsu Chemical Co., Ltd.) at a ratio of 1:1(in terms of mass ratio) was disposed. After degassing, the composition was cured by heating at 120°C for 1 hour by using a hot plate. The cured substance was peeled from the mold to obtain a first base containing a fluorine elastomer. A groove is formed on the surface of the first base, exposed by the peeling. The shape of the groove formed in the first base corresponds to the shape of the pattern of the mold. The groove depth measured with a laser optical microscope (VK8550, KEYENCE CORPORATION) was in a range of 100 μm to 105 μm.

(Step 4: Plasma treatment)

A plate made of a fluorine elastomer was prepared as a second base. Specifically, X-71C-8115A and X-71C-8115B were mixed at a ratio of 1:1(in terms of mass ratio), and an obtained mixture was heated at 120°C for 1 hour and cured to obtain the second base. The first base and the second base were disposed in a chamber of Plasma Etcher CPE-200 (SAKIGAKE-Semiconductor Co., Ltd.). An ammonia gas (NH$_3$) of 100 sccm was allowed to flow into the chamber, and plasma treatment was carried out at a radio frequency (RF) output of 100 W for 180 seconds at a pressure of 100 Pa. The treatment target surface of the first base is a surface on which the groove is formed. The treatment target surface of the second base is one surface of the second base (that is, the surface of the second base, which comes into contact with the first base in the step 5 described later).

(Step 5: Bonding)

After the plasma treatment, the plasma-treated surface of the first base (that is, the surface on which the groove of the first base was formed) was bonded to the plasma-treated surface of the second base, and an obtained microchannel device was subjected to a heating and pressurizing treatment at a temperature of 150°C for 10 minutes by using an oven in a state where a load of 100 g/cm$^2$ was applied.

In the microchannel device obtained according to the above-described procedure, a T-shaped flow channel as illustrated in Fig. 5 is formed between the first base and the second base. Using a biopsy trephine having a diameter of 1.5 mm (Kai Corporation), three opening portions (that is, holes) were formed in the first base of the microchannel device. Each opening portion is connected to the terminal of a T-shaped flow channel.

<Examples 2 to 8>

A microchannel device was produced according to the same procedure as the procedure shown in Example 1, except that the manufacturing conditions were changed according to the description in Table 1.

<Examples 9 to 11>

A microchannel device according to Example 9 was produced according to the procedures shown in the step 1, the step 2, the step 5, and the step 6 below. A microchannel device according to Example 10 was produced according to the procedures shown in the step 1, the step 2, the step 3, the step 5, and the step 6 below. A microchannel device according to Example 11 was produced according to the procedures shown in the step 1, the step 2, the step 3, the step 4, the step 5, and the step 6 below.

(Step 1: Preparation of first base and second base)

The first base was produced according to the same procedure as the procedure shown in the step 1 to the step 3 of Example 1. A plate made of a fluorine elastomer was prepared as a second base.

(Step 2: First plasma treatment)

The first base and the second base were disposed in a chamber of Plasma Etcher CPE-200 (SAKIGAKE-Semiconductor Co., Ltd.). Ammonia gas ($NH_3$) was allowed to flow into the chamber at 100 sccm, and plasma treatment was carried out with an RF output of 100 W for 180 seconds at a pressure of 100 Pa. The treatment target surface of the first base is a surface on which the groove is formed. The treatment target surface of the second base is one surface of the second base (that is, the surface of the second base, which comes into contact with the first base in the step 5 described later).

(Step 3: Second plasma treatment)

An oxygen gas ($O_2$) instead of the ammonia gas ($NH_3$) was allowed to flow into the chamber at 100 sccm, and plasma treatment was carried out with an RF output of 300 W for 100 seconds at a pressure of 100 Pa.

(Step 4: Third plasma treatment)

An ammonia gas ($NH_3$) instead of the oxygen gas ($O_2$) was allowed to flow into the chamber at 100 sccm, and plasma treatment was carried out with an RF output of 100 W for 180 seconds at a pressure of 100 Pa.

(Step 5: Bonding)

After the series of plasma treatments, the plasma-treated surface of the first base (that is, the surface on which the groove of the first base was formed) was bonded to the plasma-treated surface of the second base. In the obtained microchannel device, a T-shaped flow channel as illustrated in Fig. 5 is formed between the first base and the second base. The width of the flow channel is 300 $\mu$m. Using a biopsy trephine having a diameter of 1.5 mm (Kai Corporation), three opening portions (that is, holes) were formed in the first base of the microchannel device. Each opening portion is connected to the terminal of a T-shaped flow channel.

(Step 6: Hydrophilization treatment)

A PFA tube (outer diameter: 1/16 "inch, inner diameter: 0.5 mm) is inserted into each opening portion in a state where a load of 100 g/cm$^2$ is applied to the microchannel device, and then a syringe pump (PHD4400, HARVARD Apparatus) was used to flow pure water containing 5% by mass of "Pluronic F127" (BASF SE) in a flow channel at a flow rate of 3 mL/hour for 5 minutes. PFA is a fluororesin called perfluoroalkoxyalkane. After extruding the liquid in the flow channel with compressed air, a heating and pressurizing treatment was carried out at a temperature of 150°C for 10 minutes using an oven. The microchannel device taken out from the oven was cooled. Next, pure water containing 5% by mass of "Pluronic F127" (BASF SE) was allowed to flow into the flow channel at a flow rate of 3 mL/hour for 5 minutes by using a syringe pump (PHD4400, HARVARD Apparatus). By allowing "Pluronic F127" to flow into the flow channel, the surface of the first base and the surface of the second base that faces the inside of the flow channel were subjected to the hydrophilization treatment.

<Example 12>

A microchannel device was produced according to the same procedure as the procedure shown in Example 11, except that in the step 6 (the hydrophilization treatment), "Pluronic F68" was used instead of "Pluronic F127".

<Comparative Examples 1 to 5>

A microchannel device was produced according to the same procedure as the procedure shown in Example 1, except that the manufacturing conditions were changed according to the description in Table 1.

<Measurement>

(Contact angle)

Microchannel devices for measuring a contact angle were produced according to the same procedures as the procedures described in corresponding Examples and Comparative Examples, except that the method of the hydrophilization treatment was changed and the width of the flow channel was changed to 5 mm. In the hydrophilization treatment, the microchannel device was immersed in the treatment liquid instead of allowing the treatment liquid for the hydrophilization treatment to flow into the flow channel. The microchannel device for measuring a contact angle was cut using a cutter to expose the surface of the first base that defined the flow channel. The surface of the first base that defined the flow channel was washed with acetone and ethanol and then dried by air blowing. 2 μL of pure water was dropwise added onto the surface of the first base that defined the flow channel. The contact angle of the liquid droplet one second after the contact of the pure water with the surface of the first base that defines the flow channel was measured using DMs-401 manufactured by Kyowa Interface Science Co., Ltd. The contact angle of pure water on the surface of the second base that defined the flow channel was measured according to the same method as described above. The measurement results are shown in Table 1.

<Evaluation>

(Solvent resistance)

In order to evaluate the solvent resistance, three microchannel devices were prepared in each of Examples and Comparative Examples. Three kinds of solvents shown below were respectively allowed to flow into the flow channels of the three microchannel devices. Methyl ethyl ketone (FUJIFII,M Wako Pure Chemical Corporation) was allowed to flow into the flow channel of the first microchannel device at a flow rate of 1 mL/hour for 10 minutes. Toluene (FUJIFILM Wako Pure Chemical Corporation) was allowed to into the flow channel of the second microchannel device at a flow rate of 1 mL/hour for 10 minutes. Ethyl acetate (FUJIFILM Wako Pure Chemical Corporation) was allowed to into the flow channel of the third microchannel device at a flow rate of 1 mL/hour for 10 minutes. After the flow of the organic solvent, the minimum value of the width of the flow channel of the microchannel device was measured. Based on the rate of change X in the width of the flow channel determined according to the following expression, the solvent resistance was evaluated according to the following criteria. The evaluation results are shown in Table 1.

$$\text{Expression: Rate of change in width (300 μm) of flow channel} = ([\text{width of flow channel before test}] - [\text{minimum value of width of flow channel after test}])/[\text{width of flow channel before test}] \times 100$$

- Criteria -

A: The rate of change X in the width of the flow channel of all the microchannel devices satisfies $-5\% \leq X \leq +5\%$.

B: The rate of change X in the width of the flow channel of at least one microchannel device satisfies $X < -5\%$ or $+5\% < X$.

(Bondability)

The second base was carefully peeled manually from the first base of the microchannel device to obtain a test piece separated on the first base side and a test piece separated on the second base side. Five different regions on a surface (hereinafter, referred to as a "target surface") of the test piece separated on the first base side, which was exposed by peeling, were subjected to scanning using a laser optical microscope (VK8550, KEYENCE CORPORATION) with a width of 300 μm (that is, scanning distance of a laser) The arithmetic average roughness Ra of the target surface was calculated. The larger value of Ra indicates the higher bondability, that is, the higher adhesiveness between the first base and the second base.

[Table 1]

| | No. | Base | | Plasma treatment | | | | Bonding | | | | Hydrophilization treatment | Contact angle | | Evaluation | |
|---|---|---|---|---|---|---|---|---|---|---|---|---|---|---|---|---|
| | | Component | Order | Gas kind | RF output | Time | Time taken from end of plasma treatment to start of bonding | Load | Temperature | Time | | | First base | Second base | Bondabilily (Surface roughness Ra) | Solvent res istance |
| Comparative Example | 1 | Polydimethyl siloxane | 1 | $O_2$ | 20 W | 20 seconds | 5 minutes | - | 25°C | 1 minute | - | | 109° | 109° | 31 $\mu$m | a |
| Comparative Example | 2 | fluorine elas-tomer | 1 | $O_2$ | 20 W | 20 seconds | 5 minutes | - | 25°C | 1 minute | - | | 117° | 117° | 0.1 $\mu$m | A |
| Comparative Example | 3 | Fluorine elas-tomer | 1 | $O_2$ | 20 W | 20 seconds | 5 minutes | 100 g/cm$^2$ | 150°C | 10 min-utes | - | | 111° | 111° | 0.1 $\mu$m | A |
| Comparative Example | 4 | Fluorine elas-tomer | I | $NH_3$ | 100 W | 180 seconds | 5 minutes | 100 g/cm$^2$ | 25°C | 10 min-utes | - | | 117° | 117° | 0.1 $\mu$m | A |
| Comparative Example | 5 | Fluorine elas-tomer | 1 | $NH_3$ | 100 W | 20 seconds | 5 minutes | 100 g/cm$^2$ | 150°C | 10 min-utes | - | | 116° | 116° | 0.1 $\mu$m | A |
| Example | 1 | Fluorine elas-tomer | 1 | $NH_3$ | 100 W | 180 seconds | 5 minutes | 100 g/cm$^2$ | 150°C | 10 min-utes | - | | 117° | 117° | 24 $\mu$m | A |
| Example | 2 | Fluorine elas-tomer | 1 | $NH_3$ | 100 W | 180 seconds | 5 minutes | - | 150°C | 10 min-utes | - | | 116° | 116° | 3 $\mu$m | A |
| Example | 3 | Fluorine elas-tomer | 1 | $NH_3$ | 100 W | 180 seconds | 5 minutes | 100 g/cm$^2$ | 100°C | 10 min-utes | - | | 117° | 117° | 4 $\mu$m | A |
| Example | 4 | Fluorine elas-tomer | 1 | $NH_3$ | 100 W | 100 seconds | 5 minutes | 100 g/cm$^2$ | 150°C | 10 min-utes | - | | 117° | 117° | 18 $\mu$m | A |
| Example | 5 | Fluorine elas-tomer | 1 | $NH_3$ | 100 W | 300 seconds | 5 minutes | 100 g/cm$^2$ | 150°C | 10 min-utes | - | | 117° | 117° | 26 $\mu$m | A |
| Example | 6 | Fluorine elas-tomer | 1 | $NH_3$ | 100 W | 600 seconds | 5 minutes | 100 g/cm$^2$ | 150°C | 10 min-utes | - | | 117° | 117° | 6 $\mu$m | A |

(continued)

| | No. | Base | | Plasma treatment | | | | Bonding | | | | Hydrophilization treatment | Contact angle | | Evaluation | |
|---|---|---|---|---|---|---|---|---|---|---|---|---|---|---|---|---|
| | | Component | Order | Gas kind | RF output | Time | Time taken from end of plasma treatment to start of bonding | Load | Temperature | Time | | First base | Second base | Bondabilily (Surface roughness Ra) | Solvent resistance |
| Example | 7 | First base: fluorine elastomer Second base: glass | 1 | NH$_3$ | 100 W | 180 seconds | 5 minutes | 100 g/cm$^2$ | 150°C | 10 minutes | - | 117° | 96" | 17 $\mu$m | A |
| Example | 8 | First base: fluorine elastomer Second base: SUS304 | 1 | NH$_3$ | 100 W | 180 seconds | 5 minutes | 100 g/cm$^2$ | 150°C | 10 minutes | - | 117° | 98° | 12 $\mu$m | A |
| Example | 9 | Fluorine elastomer | 1 | NH$_3$ | 100 W | 180 seconds | 5 minutes | 100 g/cm$^2$ | 150°C | 10 minutes | Yes (Pluronic F127y | 111° | 111° | 9 $\mu$m | A |
| Example | 10 | Fluorine elastomer | 1 | NH$_3$ | 100 W | 180 seconds | - | - | - | - | - | - | - | - | - |
| | | | 2 | O$_2$ | 300 W | 100 seconds | 5 minutes | 100 g/cm$^2$ | 150°C | 10 minutes | Yes (Pluronic F127y | 92° | 92° | 3 $\mu$m | A |
| Example | 11 | Fluorine elastomer | 1 | NH$_3$ | 100 W | 180 seconds | - | - | - | - | - | - | - | - | - |
| | | | 2 | O$_2$ | 300 W | 100 seconds | - | - | - | - | - | - | - | - | - |
| | | | 3 | NH$_3$ | 100 W | 180 seconds | 5 minutes | 100 g/cm$^2$ | 150°C | 10 minutes | Yes (Pluronic F127) | 36° | 36° | 18 $\mu$m | A |

(continued)

| | No. | Base | | Plasma treatment | | | | Bonding | | | | Hydrophilization treatment | Contact angle | | Evaluation | |
| | | Component | Order | Gas kind | RF output | Time | Time taken from end of plasma treatment to start of bonding | Load | Temperature | Time | | | First base | Second base | Bondabilily (Surface roughness Ra) | Solvent res istance |
|---|---|---|---|---|---|---|---|---|---|---|---|---|---|---|---|---|
| Example | 12 | Fluorine elastomer | 1 | $NH_3$ | 100 W | 180 seconds | - | - | - | - | - | - | - | - | - | - |
| | | | 2 | $O_2$ | 300 W | 100 seconds | - | - | - | - | - | - | - | - | - | - |
| | | | 3 | $NH_3$ | 100 W | 180 seconds | 5 minutes | 100 g/cm$^2$ | 150°C | 10 minutes | Yes (Pluronic F68) | 36° | 36° | 17 μm | A |

Unless otherwise specified, the components described in the section of "Base" in Table 1 indicate the component of the first base and the component of the second base.

Table 1 shows that the solvent resistance and the bondability of the microchannel devices in Examples 1 to 12 are excellent as compared with the solvent resistance and the bondability of the microchannel devices in Comparative Examples 1 to 5.

<Production of liquid droplet>

Using the microchannel device produced in Example 1, water-in-oil droplets were produced according to the following procedure. Hereinafter, a specific procedure of the test will be described with reference to Fig. 5. Using a syringe pump (PHD4400, HARVARD apparatus), silicone oil (KF96-1CS, Shin-Etsu Chemical Co., Ltd.) containing 0.5% by mass of KF6017 (Shin-Etsu Chemical Co., Ltd.) was introduced into the flow channel 31 from an opening portion (not illustrated in the drawing) connected to the first flow channel part 31a at a flow rate of 10 mL/hour, and pure water was introduced into the flow channel 31 from an opening portion connected to the second flow channel part 3 1b at 3 mL/hour, whereby uniform water-in-oil droplets were obtained at the junction 31A.

Using the microchannel device produced in Example 11, oil-in-water droplets were produced according to the following procedure. Hereinafter, a specific procedure of the test will be described with reference to Fig. 5. Using a syringe pump (PHD4400, HARVARD apparatus), pure water containing 1% by mass of polyvinyl alcohol (Merck KGaA) was introduced into the flow channel 31 from an opening portion (not illustrated in the drawing) connected to the first flow channel part 31a at 10 mL/hour, and silicone oil (KF96-1CS, Shin-Etsu Chemical Co., Ltd.) was introduced into the flow channel 31 from an opening portion connected to the second flow channel part 31b at 3 mL/hour, whereby uniform oil-in-water droplets were obtained at the junction 31A (see, for example, Fig.7).

The disclosure of JP2020-141706 filed on August 25, 2020 is incorporated in the present specification by reference in its entirety. All documents, patent applications, and technical standards described in the present specification are herein incorporated by reference to the same extent that individual documents, patent applications, and technical standards have been specifically and individually indicated to be incorporated by reference, respectively.

Explanation of References

    10: first base
    20: second base
    30, 31, 32: flow channel
    31a, 32a: first flow channel part
    31b, 32b: second flow channel part
    31c, 32c: third flow channel part
    32d: fourth flow channel part
    32e: fifth flow channel part
    30A, 30B, 31A, 32A, 32B: junction
    40, 41, 42, 43: opening portion
    100: microchannel device
    D1: liquid droplet

**Claims**

**1.** A microchannel device comprising:

a first base having a defining surface that defines a flow channel and containing a polymer that contains a fluorine atom; and
a second base having a defining surface that defines the flow channel together with the defining surface of the first base, having solvent resistance, and coming into contact with the first base,
wherein an arithmetic average roughness Ra of a surface of the first base, exposed by peeling the second base from the first base, is 1 $\mu$m or more.

**2.** The microchannel device according to claim 1, wherein the second base contains at least one selected from the group consisting of a polymer that contains a fluorine atom, glass, and stainless steel.

3. The microchannel device according to claim 1 or 2, wherein a contact angle of water on the defining surface of the first base is 90° or more, and a contact angle of water on the defining surface of the second base is 90° or more.

4. The microchannel device according to claim 1 or 2, wherein the defining surface of the first base includes a region in which a surfactant is adsorbed, and on the defining surface of the first base, a contact angle of water to the region in which the surfactant is adsorbed is 60° or less, and the defining surface of the second base includes a region in which a surfactant is adsorbed, and on the defining surface of the second base, a contact angle of water to the region in which the surfactant is adsorbed is 60° or less.

5. The microchannel device according to claim 4, wherein the surfactant is an alkylene oxide polymer.

6. The microchannel device according to claim 4, wherein the surfactant is an ethylene oxide-propylene oxide copolymer.

7. The microchannel device according to any one of claims 4 to 6, wherein the defining surface of the first base further includes a region in which the surfactant is not adsorbed, and the defining surface of the second base further includes a region in which the surfactant is not adsorbed.

8. The microchannel device according to any one of claims 1 to 7, wherein the flow channel includes a first flow channel part, a second flow channel part that joins the first flow channel part, and a third flow channel part that is connected to a junction of the first flow channel part with the second flow channel part.

9. The microchannel device according to any one of claims 1 to 7, wherein the flow channel includes a first flow channel part, a second flow channel part that joins the first flow channel part, a third flow channel part that is connected to a junction of the first flow channel part with the second flow channel part, a fourth flow channel part that joins the third flow channel part, and a fifth flow channel part that is connected to a junction of the third flow channel part with the fourth flow channel part.

10. The microchannel device according to any one of claims 1 to 9, wherein the microchannel device is used for producing a liquid droplet.

11. The microchannel device according to any one of claims 1 to 9, wherein the microchannel device is used for producing an air bubble.

12. The microchannel device according to any one of claims 1 to 9, wherein the microchannel device is used for producing a microcapsule.

13. The microchannel device according to any one of claims 1 to 9, wherein the microchannel device is used for producing a multiple emulsion.

14. The microchannel device according to any one of claims 1 to 9, wherein the microchannel device is used for producing a liquid droplet that encompasses an air bubble.

15. A production method for a liquid droplet using the microchannel device according to any one of claims 1 to 9, the production method for a liquid droplet, comprising:
joining a liquid containing oil and a liquid containing water in the flow channel of the microchannel device to obtain a liquid droplet.

16. A production method for an air bubble using the microchannel device according to any one of claims 1 to 9, the production method for an air bubble, comprising:
joining a liquid and a gas in the flow channel of the microchannel device to obtain an air bubble.

17. A production method for a microcapsule using the microchannel device according to any one of claims 1 to 9, the production method for a microcapsule, comprising:
joining a liquid containing oil and a liquid containing water in the flow channel of the microchannel device to obtain a microcapsule.

18. A production method for a multiple emulsion using the microchannel device according to any one of claims 1 to 9, the production method for a multiple emulsion, comprising:
joining at least three liquids in the flow channel of the microchannel device to obtain a multiple emulsion.

19. A production method for a liquid droplet that encompasses an air bubble using the microchannel device according to any one of claims 1 to 9, the production method for a liquid droplet that encompasses an air bubble, comprising: joining a gas, a liquid containing oil, and a liquid containing water in the flow channel of the microchannel device to obtain a liquid droplet that encompasses an air bubble.

20. A manufacturing method for a microchannel device, comprising:

preparing a first base having a surface that has a groove and containing a polymer that contains a fluorine atom;
subjecting the surface of the first base to a plasma treatment in a presence of an ammonia gas;
preparing a second base having a surface for coming into contact with the first base and having solvent resistance;
subjecting the surface of the second base to a plasma treatment in a presence of an ammonia gas; and
bringing the surface of the second base, subjected to the plasma treatment, into contact with the surface of the first base, subjected to the plasma treatment, to form a flow channel defined by the first base and the second base.

# FIG. 1

100

II

20
10

II

# FIG. 2

100

20

10

30

# FIG. 3

100

20

10

40

30

# FIG. 4

100

43    42    41

40

10

30

30B    30A

## FIG. 5

31

31b

31a          31A          31c

## FIG. 6

32

32b          32d

32a     32A     32c     32B     32e

# FIG. 7

D1

| INTERNATIONAL SEARCH REPORT | International application No. |
|---|---|
| | PCT/JP2021/023220 |

A. CLASSIFICATION OF SUBJECT MATTER
Int. Cl. B81B1/00(2006.01)i, B01F3/04(2006.01)i, B01F3/08(2006.01)i, B01F5/00(2006.01)i,
B01J13/04(2006.01)i, B01J19/00(2006.01)i, B81C3/00(2006.01)i, G01N37/00(2006.01)i
FI: B81B1/00, B01F3/04 Z, B01F3/08 A, B01F5/00 D, B01J13/04, B01J19/00 321, B81C3/00, G01N37/00 101

According to International Patent Classification (IPC) or to both national classification and IPC

B. FIELDS SEARCHED

Minimum documentation searched (classification system followed by classification symbols)
Int. Cl. B81B1/00, B01F3/04, B01F3/08, B01F5/00, B01J13/04, B01J19/00,
B81C3/00, G01N37/00

Documentation searched other than minimum documentation to the extent that such documents are included in the fields searched
Published examined utility model applications of Japan      1922-1996
Published unexamined utility model applications of Japan    1971-2021
Registered utility model specifications of Japan            1996-2021
Published registered utility model applications of Japan    1994-2021

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2018-151184 A (SUMITOMO BAKELITE CO., LTD.) 27 September 2018 (2018-09-27), paragraphs [0013]-[0015], [0039], [0053], [0056], [0070]-[0072], [0075], fig. 1 | 1-20 |
| Y A | JP 11-302387 A (NITTO DENKO CORP.) 02 November 1999 (1999-11-02), paragraphs [0012], [0018], [0042], paragraphs [0012], [0018], [0042] | 1-19 20 |
| Y A | JP 2013-534632 A (TRINEAN NV) 05 September 2013 (2013-09-05), paragraphs [0004], [0026], paragraphs [0004], [0026] | 4-19 1, 20 |

☒ Further documents are listed in the continuation of Box C. ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04.08.2021 | 17.08.2021 |

| Name and mailing address of the ISA/ Japan Patent Office 3-4-3, Kasumigaseki, Chiyoda-ku, Tokyo 100-8915, Japan | Authorized officer Telephone No. |
|---|---|

Form PCT/ISA/210 (second sheet) (January 2015)

**INTERNATIONAL SEARCH REPORT**

International application No.

PCT/JP2021/023220

C (Continuation).    DOCUMENTS CONSIDERED TO BE RELEVANT

| Category* | Citation of document, with indication, where appropriate, of the relevant passages | Relevant to claim No. |
|---|---|---|
| Y<br>A | JP 2019-89067 A (THE PRESIDENT & FELLOWS OF HARVARD COLLEGE) 13 June 2019 (2019-06-13), paragraphs [0064], [0077], paragraphs [0064], [0077] | 10-19<br>1-9, 20 |
| Y<br>A | JP 2004-351417 A (JAPAN SCIENCE AND TECHNOLOGY AGENCY) 16 December 2004 (2004-12-16), paragraphs [0065], [0066], paragraphs [0065], [0066] | 10-19<br>1-9, 20 |
| Y<br>A | JP 2017-209671 A (THE PRESIDENT & FELLOWS OF HARVARD COLLEGE) 30 November 2017 (2017-11-30), paragraph [0060], paragraph [0060] | 10-19<br>1-9, 20 |
| Y<br>A | JP 4-349672 A (CANON INC.) 04 December 1992 (1992-12-04), paragraph [0008], paragraph [0008] | 20<br>1-19 |

Form PCT/ISA/210 (continuation of second sheet) (January 2015)

INTERNATIONAL SEARCH REPORT

Information on patent family members

International application No.

PCT/JP2021/023220

| Patent Documents referred to in the Report | Publication Date | Patent Family | Publication Date |
|---|---|---|---|
| JP 2018-151184 A | 27.09.2018 | (Family: none) | |
| JP 11-302387 A | 02.11.1999 | (Family: none) | |
| JP 2013-534632 A | 05.09.2013 | US 2013/0108801 A1 paragraphs [0004], [0025] EP 2404867 A1 | |
| JP 2019-89067 A | 13.06.2019 | US 2016/0008778 A1 paragraphs [0078], [0091] EP 2964390 A1 CN 105050718 A | |
| JP 2004-351417 A | 16.12.2004 | US 2004/0068019 A1 paragraphs [0099], [0100] EP 1362634 A1 DE 60211857 T2 | |
| JP 2017-209671 A | 30.11.2017 | US 2006/0163385 A1 paragraph [0069] EP 2127736 A1 | |
| JP 4-349672 A | 04.12.1992 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009047438 A

- JP 2020141706 A

**Non-patent literature cited in the description**

- **IKUKO MORITA ; YASUHISA ANDO ; YUN JUNG HEO.** Microsphere formation using SIFEL microfluidic devices with organic-solvent resistance. *Journal of Advanced Mechanical Design, Systems, and Manufacturing,* 2017, vol. 11 (2